# EUROPEAN PATENT SPECIFICATION

(11) **EP 2 644 380 B1**
(45) Date of publication and mention of the grant of the patent: **15.06.2016**
(21) Application number: 13161299.6
(22) Date of filing: 27.03.2013
(51) Int. Cl.: B41C 1/10, G03F 7/004

(54) **Lithographic printing plate precursor**
Lithografiedruckplattenvorläufer
Précurseur de plaque d'impression lithographique

(30) Priority: 27.03.2012 JP 2012072539
(43) Date of publication of application: 02.10.2013
(73) Proprietor: Fujifilm Corporation, Minato-ku Tokyo (JP)
(72) Inventor: Fujiki, Yuzo, Shizuoka (JP)
(74) Representative: Hoffmann Eitle

(56) References cited:
- JP-A- 2002 090 985
- JP-A- 2004 102 112

## Description

### FIELD OF THE INVENTION

The present invention relates to a lithographic printing plate precursor of gum development type or on-press development type which is capable of undergoing a direct plate making by image exposure with laser, and in particular, to a lithographic printing plate precursor which provides a lithographic printing plate excellent in printing durability and tone reproducibility.

### BACKGROUND OF THE INVENTION

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-recording layer) is heretofore used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.

Due to the recent progress in the technical field, nowadays the lithographic printing plate can be obtained by a CTP (computer-to-plate) technology. Specifically, a lithographic printing plate precursor is directly subjected to scanning exposure using laser or laser diode without using a lith film and developed to obtain the lithographic printing plate.

With the progress described above, the issue on the lithographic printing plate precursor has transferred to improvements, for example, in image-forming property corresponding to the CTP technology, printing property or physical property. Also, with the increasing concern about global environment, as another issue on the lithographic printing plate precursor, an environmental problem on waste liquid discharged accompanying the wet treatment, for example, development processing comes to the front

In response to the environmental problem, simplification of development or plate making or non-processing has been pursued. As one method of simple plate making, a method referred to as an "on-press development" is practiced. Specifically, according to the method after exposure of a lithographic printing plate precursor, the lithographic printing plate precursor is mounted as it is on a printing machine without conducting conventional development and removal of the unnecessary area of image-recording layer is performed at an early stage of printing process.

Also, as a method of simple development, a method referred to as a "gum development" is practiced in which removal of the unnecessary area of image-recording layer is performed using not a conventional highly alkaline developer but a finisher or gum solution of near-neutral pH.

In the simplification of plate making operation as described above, a system using a lithographic printing plate precursor capable of being handled in a bright room or under a yellow lamp and a light source is preferred from the standpoint of workability. Thus, as the light source, a semiconductor laser emitting an infrared ray having a wavelength of 760 to 1,200 or a solid laser, for example, YAG laser, is used. An UV laser is also used.

As the lithographic printing plate precursor capable of undergoing on-press development, for instance, a lithographic printing plate precursor having provided on a hydrophilic support, an image-recording layer (heat-sensitive layer) containing microcapsules having a polymerizable compound encapsulated therein is described in JP-A-2001-277740 (the term "JP-A" as used herein means an "unexamined published Japanese patent application") and JP-A-2001-277742. A lithographic printing plate precursor having provided on a support, an image-recording layer (photosensitive layer) containing an infrared absorbing agent, a radical polymerization initiator and a polymerizable compound is described in JP-A-2002-287334. A lithographic printing plate precursor capable of undergoing on-press development having provided on a support, an image-recording layer containing a polymerizable compound and a graft polymer having a polyethylene oxide chain in its side chain or a block polymer having a polyethylene oxide block is described in U.S. Patent Publication No. 2003/0064318.

In the lithographic printing plate precursor having an image-recording layer containing a radical polymerization initiator and a polymerizable compound, it is know to add to the image-recording layer a heterocyclic thiol compound, for example, a 2-mercaptobenzimidazole, a 2₋mercaptobenzothiazole or a 3-mercaptotriazole, which is referred to as a co-sensitizer or a chain transfer agent in order to achieve high sensitivity and high printing durability of a lithographic printing plate obtained (see for example, JP-A-2006-091479 and JP-A-2011-051350).

However, it is difficult for these techniques to satisfy both of high printing durability and tone reproducibility of a lithographic printing plate obtained.

JP2002090985A describes a planographic printing original plate comprising a substrate and a photosensitive layer disposed thereon, wherein the photosensitive layer comprises: *inter alia,* (A) an infrared absorption agent, (B) a thermal radical generator, (C) a radical polymerizable compound and (E) at least one of compounds of formulae (I) - (III): 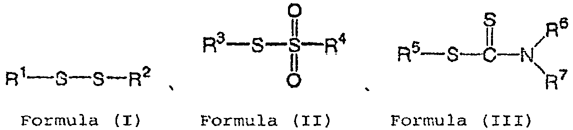 wherein R¹-R⁷ are each a hydrocarbon group and R⁶ and R⁷ may bond to each other to form a ring.

JP2004102112A describes a polymerizable composition of a recording layer of a planographic printing original plate comprising (A) a photothemal converting agent, (B) a polymerizable compound and (C) a polymerization initiator having a structure represented by a general formula (I) or (II): 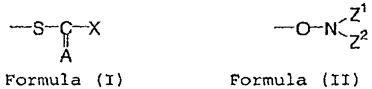 wherein X is an amino group, an alkyl group, or an aryl group, A is an oxygen atom or a sulfur atom, and Z¹ and Z² are independently a hydrogen atom, an alkyl group, an aryl group, an amino group, a carbonyl group, an alkenyl group, or a halogen atom and may be combined with each other to form a ring structure.

### SUMMARY OF THE INVENTION

An object of the present invention is to provide a lithographic printing plate precursor which provides a lithographic printing plate excellent in both of printing durability and tone reproducibility.

A lithographic printing plate precursor is provided as defined in claims 1-9.

According to the present invention, a lithographic printing plate precursor which provides a lithographic printing plate excellent in both of printing durability and tone reproducibility can be provided. Also, according to the present invention, a lithographic printing plate precursor of gum development type or on-press development type which is capable of undergoing a direct plate making by image exposure with laser and provides a lithographic printing plate excellent in both of printing durability and tone reproducibility can be provided.

### BRIEF DESCRIPTION OF THE DRAWINGS

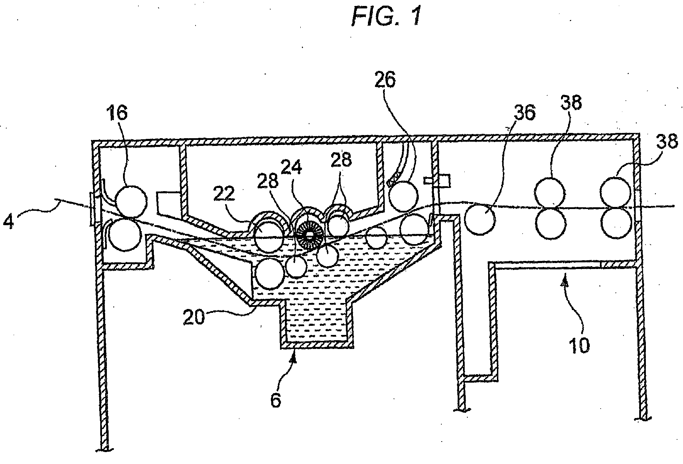

Fig. 1 is a configuration view schematically showing an automatic development processor.

### [Description of reference numerals and signs]

- 4:: Lithographic printing plate precursor (PS plate)
- 6:: Developing unit
- 10:: Drying unit
- 16:: Carrying-in roller
- 20:: Developing tank
- 22:: Transport roller
- 24:: Brush roller
- 26:: Squeeze roller (carrying-out roller)
- 28:: Backup roller
- 36:: Guide roller
- 38:: Skewer roller

### DETAILED DESCRIPTION OF THE INVENTION

The lithographic printing plate precursor according to the invention comprises an image-recording layer and a support, wherein the image-recording layer contains (A) a radical generator, (B) a polymerizable compound, (C) a specific reversible addition fragmentation chain transfer agent as defined in claim 1 and (D) a sensitizing dye. The lithographic printing plate precursor according to the invention may comprise an undercoat layer between the support and the image-recording layer, if desired. Also, the lithographic printing plate precursor according to the invention may comprise a protective layer on the image-recording layer.

The constituting components of the lithographic printing plate precursor according to the invention will be described below.

### [Image-recording layer]

The image-recording layer according to the invention contains (A) a radical generator, (B) a polymerizable compound, (C) a specific reversible addition fragmentation chain transfer agent as defined in claim 1 and (D) a sensitizing dye (particularly, a sensitizing dye having an absorption maximum in a wavelength range from 350 to 450 nm or an infrared absorbing agent having an absorption maximum in a wavelength range from 750 to 1,400 nm). Although it is known that an image-recording layer containing (A) a radical generator, (B) a polymerizable compound and (D) a sensitizing dye is an image-recording layer capable of undergoing on-press development or gum development, the present invention is characterized by incorporating (C) a specific reversible addition fragmentation chain transfer agent as defined in claim 1 into the image-recording layer and thus, both of excellent printing durability and tone reproducibility of a lithographic printing plate obtained can be achieved.

The image-recording layer according to the invention may contain, if desired, components, for example, (E) an organic borate compound, a polymer fine particle or (F) a binder polymer, in addition to the components described above.

Respective components which can be incorporated into the image-recording layer will be described in order below.

### (A) Radical generator

The radical generator (A) which can be used in the invention indicates a compound which initiates or accelerates polymerization of a polymerizable compound (B). The radical generator for use in the invention includes, for example, known thermal polymerization initiators, compounds containing a bond having small bond dissociation energy and photopolymerization initiators.

The radical generator according to the invention include, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfane compound, (j) an oxime ester compound and (k) an onium salt compound.

As the organic halide (a), compounds described in Paragraph Nos. [0022] to [0023] of JP-A-2008-195018 are preferred.

As the carbonyl compound (b), compounds described in Paragraph No. [0024] of JP-A-2008-195018 are preferred.

As the azo compound (c), for example, azo compounds described in JP-A-8-108621 are used.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azide compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate compound (h), for example, compounds described in Paragraph No. [0028] of JP-A-2008-195018 are preferred.

As the disulfone compound (i), for example, compounds described in JP-A-61-166544 and JP-A-2002-328465 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S. I. Schlesinger, Photogr. Sci. Eng., 18, 387 (1974) and T. S. Bal et aL, Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848 and JP-A-2008-195018, sulfonium salts described in European Patents 370,693,390,214,233,567,297,443 and 297,442, U.S. Patents 4,933,377, 4,760,013, 4,734,444 and 2,833,827 and German Patents 2,904,626, 3,604,580 and 3,604,581, selenonium salts described in J. V. Crivello et al., Macromolecules, 10 (6), 1307 (1977) and J. V. Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.

Of the radical generators described above, the onium salt, in particular, the iodonium salt, the sulfonium salt or the azinium salt, and the hexaarylbiimidazole compound are more preferred. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodoniumtetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate and tris(4-chlorophenyl)sulfonium 3,5-bis(methoxycarbonyl)benzenesulfonate.

Examples of the azinium salt include 1-cyclohexylmethyloxypyridinium. hexafluorophosphate, 1-cyclohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

Examples of the hexaarylbiimidazole compound include 2,2'-bis(o-chlorophenyl)-4,4',5,5'-tetraphenylbiimidazole, 2,2'-bis(o-bromophenyl)4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5-tetraphenylbiimidazole.

The radical generator can be added preferably in an amount from 0.1 to 50% by weight, more preferably from 0.5 to 30% by weight, particularly preferably from 0.8 to 20% by weight, based on the total solid content of the image-recording layer. In the range described above, good sensitivity and good stain resistance in the non-image area at the time of printing are obtained. (B) Polymerizable compound

The polymerizable compound (B) which can be used in the invention is an addition-polymerizable compound having at least one ethylenically unsaturated double bond, and it is preferably selected from compounds having at least one, preferably two or more, terminal ethylenically unsaturated double bonds. Such compounds are widely known in the field of art and they can be used in the invention without any particular restriction. The compound has a chemical form, for example, a monomer, a prepolymer, specifically, a dimer, a trimer or an oligomer, or a mixture thereof, or a (co)polymer thereof.

Specific examples of the Polymerizable compound include compounds described in Paragraph Nos. [0089] to [0098] of JP-A-2008-195018. Among them, esters of an aliphatic polyhydric alcohol compound with an unsaturated carboxylic acid (for example, acrylic acid, methacrylic acid, itaconic acid, crotonic acid, isocrotonic acid or maleic acid) are preferably exemplified. Other preferred polymerizable compounds include polymerizable compounds containing an isocyanuric acid structure described in JP-A-2005-329708.

Of the compounds described above, isocyanuric acid ethylene oxide-modified acrylates, for example, tris(acryloyloxyethyl) isocyanurate or bis(acryloyloxyethyl)hydroxyethyl isocyanurate are particularly preferred, because they are excellent in balance between hydrophilicity relating to the on-press development property and polymerization ability relating to the printing durability.

In the invention, the polymerizable compound (B) is preferably used in an amount from 5 to 80% by weight, more preferably from 15 to 75% by weight, based on the total solid content of the image-recording layer.

### (C) Reversible addition fragmentation chain transfer agent (RAFT agent)

The reversible addition fragmentation chain transfer agent for use in the invention is a chain transfer agent capable of generating reversible addition fragmentation chain transfer polymerization. The RAFT agent provides a living property to radical polymerization and is not accompanied with a side reaction which deactivates a growing terminal, for example, an irreversible chain transfer reaction or a termination reaction in the polymerization process (see, for example, Macromolecules, Vol. 36, No. 7, pp. 2256 to 2272 (2003)).

The invention is characterized by using the specific reversible addition fragmentation chain transfer agent (hereinafter referred to as a RAFT agent) as defined in claim 1. The inventors have found that the achievement of satisfying both of high printing durability and tone reproducibility, which has been heretofore difficult, can be made by incorporating the RAFT agent into the image-recording layer. It is presumed that this is because the RAFT agent makes it possible not only to perform a polymerization reaction to an extent capable of providing high printing durability in the exposing step but also to reduce molecular weight distribution of a polymer obtained by the polymerization reaction.

The RAFT agent is represented by one of formulae (1) to (3) shown below.

The RAFT agent is preferably not a polymer but a low molecular weight compound, and preferably has a weight average molecular weight of 1,200 or less from the standpoint of diffusibility in the image-recording layer.

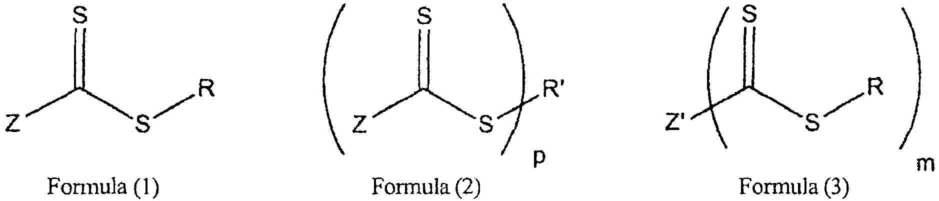

In formulae (1) to (3), Z represents any group selected from an alkyl group, an aryl group and an alkylthio group, and each of these groups may or may not have a substituent. Examples of the substituent include a phenyl group, a naphthyl group, an amino group, a nitro group, a sulfo group, a vinyl group, a hydroxy group, a carboxyl group, a cyano group, an aldehyde group, a bromo group, a chloro group, an iodo group, a fluoro group, a trifluoromethyl group, a methoxycarbonyl group and a methoxy group.

The alkyl group preferably has from 1 to 18 carbon atoms and specific examples thereof include a methyl group, an ethyl group, an isopropyl group, a tert-butyl group, a 2-ethylhexyl group, an octyl group, a dodecyl group and a stearyl group. Specific examples of the aryl group include a phenyl group, a naphthyl group and a chlorophenyl group. The alkylthio group preferably has from 1 to 18 carbon atoms and specific examples thereof include an ethylthio group, a propylthio group, a tert-butylthio group and a dodecylthio group.

Z is preferably an alkyl group having from 1 to 18 carbon atoms, an alkylthio group having from 1 to 18 carbon atoms, a phenyl group, a 4-chlorophenyl group and a naphthyl group, and more preferably a phenyl group, a 4-chlorophenyl group and a naphthyl group. By using the RAFT agent having such a group, a lithographic printing plate precursor providing good printing durability and tone reproducibility can be obtained.

R represents any group selected from an alkyl group and an alkylthio group, and each of these groups may have a substituent.

The alkyl group represented by R is preferably an alkyl group having from 1 to 18 carbon atoms, and more preferably an alkyl group having from 1 to 8 carbon atoms.

Also, the alkyl group is preferably a secondary or tertiary alkyl group and as the secondary alkyl group, that having from 3 to 8 carbon atoms is preferred, and as the tertiary alkyl group, that having from 4 to 8 carbon atoms is preferred.

Examples of the substituent for the alkyl group include an aryl group, an acyloxy group, an alkoxycarbonyl group, a cyano group, a carboxyl group and a vinyl group.

Further, a compound having as a substituent for α-position carbon atom of the alkyl group, an aryl group, a cyano group, a vinyl group or an alkoxycarbonyl group is preferred. Particularly, a compound which has two alkyl groups at the a position carbon atom of the alkyl group and is substituted with an aryl group, a cyano group, a vinyl group or an alkoxycarbonyl group is preferred.

Preferred specific examples of the alkyl group represented by R include -C(CH₃)₂CH₂C(CH₃)₃, -C(CH₃)_{3,} -C(CH₃)₂CN, -C(CH₃)₂Ph, -C(CH₃)(CN)Ph, -C(CH₃)₂COOEt, -C(CH₃)₂PhCl, -CH(CH₃)CN, -CH(CH₃)Ph, -CH₂CN, -CH₂Ph, -CH(CH₃)OAc, -C(CH₃)(OCH₃)Ph, -CH₂COOEt, -CH₂CH=CH₂, -C(CH₃)(CN)COOH and -CH₂COOH. Specific examples of the alkylthio group include -SC(CH₃)₃.

Of the alkyl groups, -C(CH₃)₂CN, -C(CH₃)₂Ph, -C(CH₃)(CN)Ph, -C(CH₃)₂COOEt and -C(CH₃)₂PhCl are preferred. By using the RAFT agent having such a group, a lithographic printing plate precursor providing good printing durability and tone reproducibility can be obtained.

Of the combinations of Z and R, combinations where Z is any of a phenyl group, a 4-chlorophenyl group and a naphthyl group and R is any of -C(CH₃)₂CN, -C(CH₃)₂Ph, -C(CH₃)(CN)Ph, -C(CH₃)₂COOEt and -C(CH₃)₂PhCl are more preferred.

Z' represents an m-valent connecting group composed of at least one benzene ring.

R' represents a p-valent connecting group composed of combination of structural units shown below.

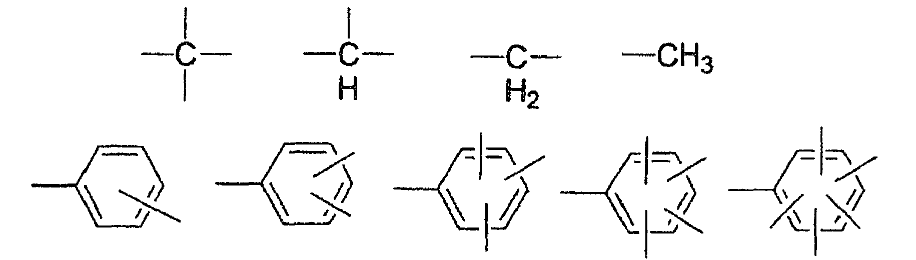

p represents an integer from 2 to 6. m represents an integer from 2 to 4. p is preferably an integer from 4 to 6. m is preferably 2.

Z' is preferably an m-valent connecting group having a benzene ring. The connecting group may have a substituent.

Examples of the substituent include a phenyl group, a naphthyl group, an amino group, a nitro group, a sulfo group, a vinyl group, a hydroxy group, a carboxyl group, a cyano group, an aldehyde group, a bromo group, a chloro group, an iodo group, a fluoro group, a trifluoromethyl group, a methoxycarbonyl group and a methoxy group.

R' is preferably a p-valent connecting group having a benzene ring. In particular, a connecting group in which the benzene ring is present as a benzyl structure is preferred The connecting group may have a substituent

Examples of the substituent include a phenyl group, a naphthyl group, an amino group, a nitro group, a sulfo group, a vinyl group, a hydroxy group, a carboxyl group, a cyano group, an aldehyde group, a bromo group, a chloro group, an iodo group, a fluoro group, a trifluoromethyl group, a methoxycarbonyl group and amethoxy group.

Specific examples of the RAFT agent (C) are set forth below, but the invention should not be construed as being limited thereto.

The numeral in parentheses with respect to the name of compound indicates a number of the compound.

### (1) Benzyl dithiobenzoate (Mw: 244.38)

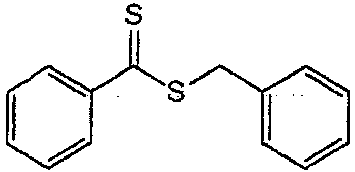

### (2) 1-Phenylethyl dithiobenzoate (Mw: 258.40)

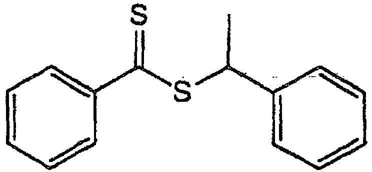

### (3) 2-Phenylprop-2-yl dithiobenzoate (Mw: 272.43)

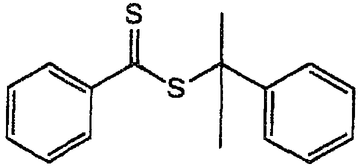

### (4) 1-Acetoxyethyl dithiobenzoate (Mw: 240.34)

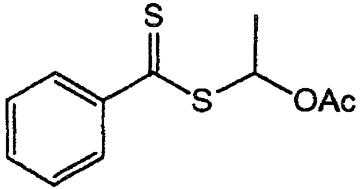

### (5) Hexakis(thiobenzoylthiomethyl)benzene (Mw: 1,075.70)

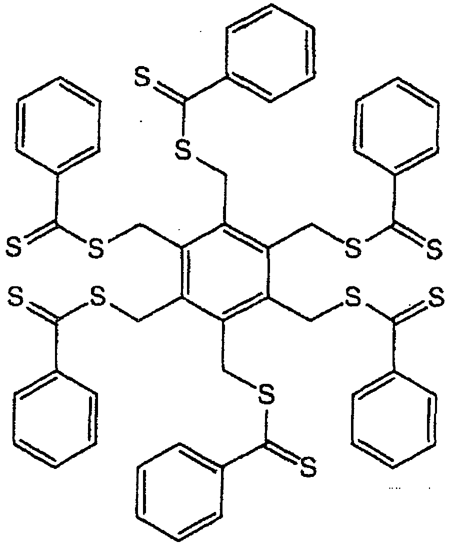

### (6) 1,4-Bis(thiobenzoylthiomethyl)benzene (Mw: 410.64)

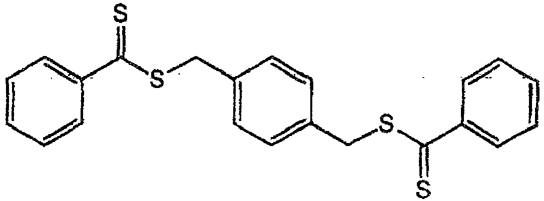

### (7) 1,2,4,5-Tetrakis(thiobenzoylthiomethyl)benzene (Mw: 743.17)

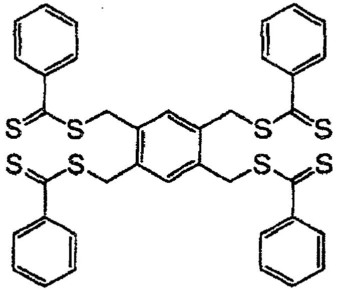

### (8) 1,4-Bis(2-thiobenzolythio)prop-2-yl)benzene (Mw: 466.75)

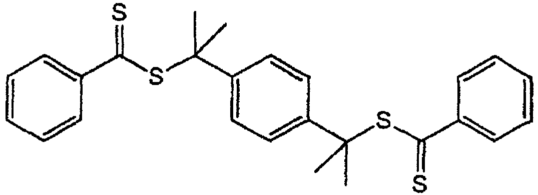

### (9) 1-(4-Methoxyphenyl)ethyl dithiobenzoate (Mw: 288.43)

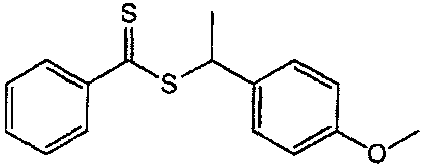

### (10) Benzyl dithioacetate (Mw: 182.31)

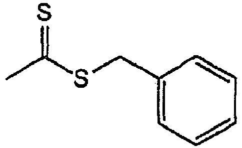

### (11) Ethoxycarbonylmethyl dithioacetate (Mw: 178.27)

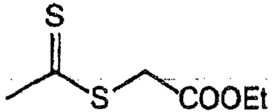

### (12) 2-(Ethoxycarbonyl)prop-2-yl dithiobenzoate (Mw: 268.40)

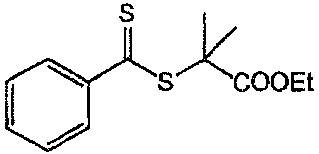

### (13) 2-cyanoprop-2-yl dithiobenzoate (Mw: 221.34)

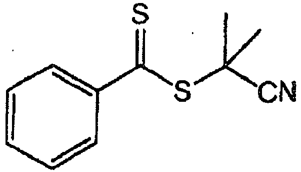

### (14) tert-Butyl dithiobenzoate (Mw: 210.36)

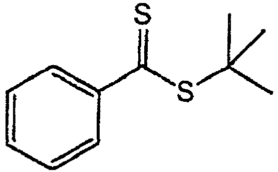

### (15) 2,4,4-Trimethylpent-2-yl dithiobenzoate (Mw: 266.47)

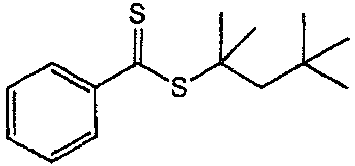

### (16) 2-(4-Chlorophenyl)prop-2-yl dithiobenzoate (Mw: 306.88)

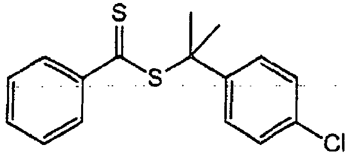

### (17) 4-Vinylbenzyl dithiobenzoate (Mw: 274.41)

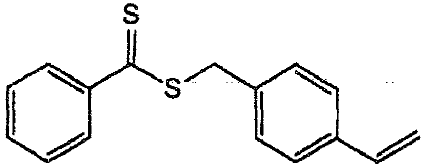

### (18) tert-Butyl trithiobenzoate (Mw: 242.43)

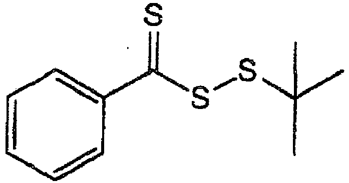

### (19) 2-Phenylprop-2-yl 4-chlorodithiobenzoate (Mw: 306.88)

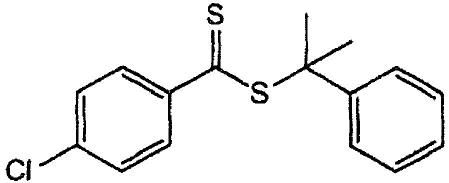

### (20) 2-Phenylprop-2-yl 1-dithionaphthoate (Mw: 322.49)

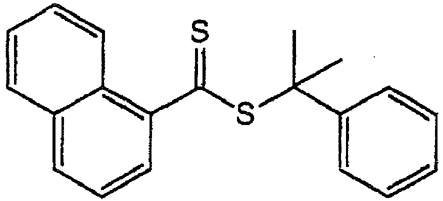

### (21) 4-Carboxy-2-cyanobut-2-yl dithiobenzoate (Mw: 279.38)

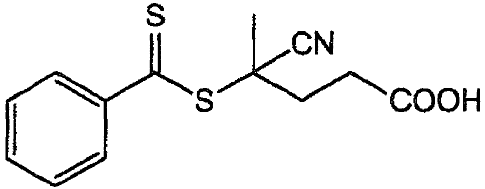

### (22) Dibenzyl tetrathioterephthalate (Mw: 410.64)

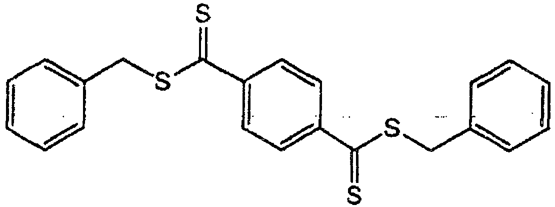

### (23) Tribenzyl hexathioterephthalate (Mw: 576.91)

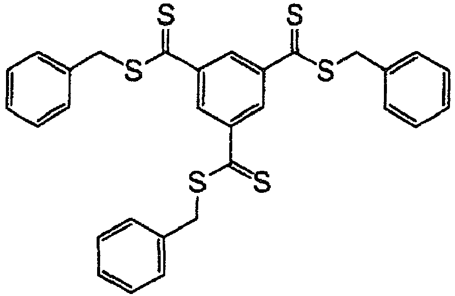

### (24) Dibenzyl trithiocarbonate (Mw: 290.47)

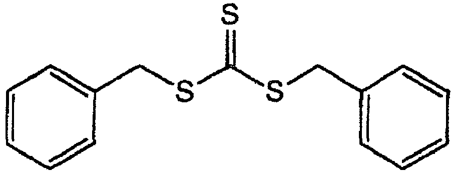

### (25) Carboxymethyl dithiobenzoate (Mw: 212.29)

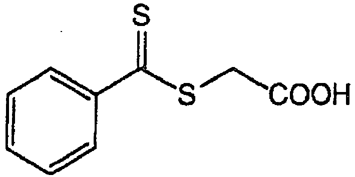

### (26) 1-Phenyl-1-cyanoethyl dithiobenzoate (Mw: 283.41)

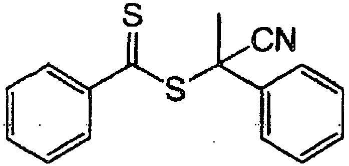

Of the compounds described above, those indicated by the numbers of the compounds shown below are preferred.

(1), (2), (3), (4), (5), (6), (7), (8), (9), (12), (13), (14), (15), (16), (17), (19), (20), (21), (25) and (26)

Among them, compounds indicated by the numbers of the compounds shown below are more preferred.

(3), (8), (12), (13), (16), (19), (20), (21) and (26)

The RAFT agent according to the invention can be synthesized by known methods. Also, commercially available compounds, for example, from Sigma-Aldrich Co. can also be used.

The amount of the RAFT agent added is preferably from 0.01 to 30% by weight, more preferably from 0.5 to 20% by weight, most preferably from 1 to 10% by weight, as to the radical generator (A). In the range of the amount described above, good tone reproducibility is obtained while maintaining high printing durability.

### (D) Sensitizing dye

The image-recording layer according to the invention contains a sensitizing dye. The sensitizing dye can be used without particular restriction as long as it absorbs light at the image exposure to form the excited state and provides energy to the radical generator with electron transfer, energy transfer or heat generation thereby increasing the polymerization initiation function. Particularly, a sensitizing dye having an absorption maximum in a wavelength range from 350 to 450 nm or from 750 to 1,400 nm is preferably used.

Examples of the sensitizing dye having an absorption maximum in a wavelength range from 350 to 450 nm include a merocyanine dye, a benzopyran, a coumarin, an aromatic ketone and an anthracene.

Of the sensitizing dyes having an absorption maximum in a wavelength range from 350 to 450 nm, a dye represented by formula (1) shown below is more preferred in view of high sensitivity.

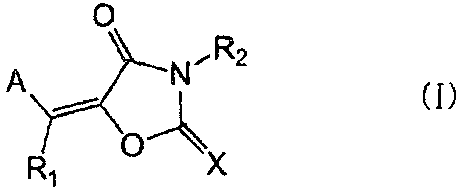

In formula (I), A represents an aromatic cyclic group which may have a substituent or a heterocyclic group which may have a substituent, X represents an oxygen atom, a sulfur atom or N(R₃), and R₁, R₂ and R₃ each independently represents a hydrogen atom or a monovalent non-metallic atomic group, or A and R₁ or R₂ and R₃ may be combined with each other to form an aliphatic or aromatic ring.

The formula (I) will be described in more detail below. R₁, R₂ and R₃ each independently represents a hydrogen atom or a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Now, A in formula (I) is described below. A represents an aromatic cyclic group which may have a substituent or a heterocyclic group which may have a substituent. Specific examples of the aromatic cyclic group which may have a substituent and heterocyclic group which may have a substituent are same as those for the substituted or unsubstituted aryl group and substituted or unsubstituted aromatic heterocyclic residue described for any one of R₁, R₂ and R₃ in formula (I), respectively.

Specific examples of the sensitizing dye include compounds described in Paragraph Nos. [0047] to [0053] of JP-A-2007-58170.

Further, sensitizing dyes represented by formulae (II) or (III) shown below can also be used.

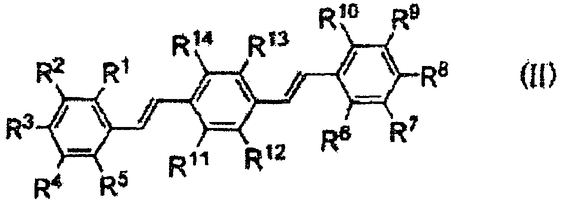

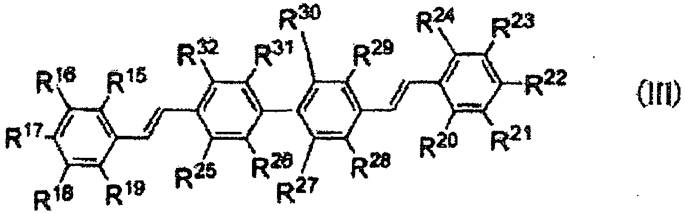

In formula (II), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

In formula (III), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

As specific examples of the sensitizing dye, compounds described in EP-A-1349006 and WO 2005/029187 are preferably used.

Further, sensitizing dyes described in JP-A-2007-171406, JP-A-2007-206216, JP-A 2007-206217, JP-A-2007-225701, JP-A-2007-225702, JP-A-2007-316582 and JP-A-2007-328243 are also preferably used.

The sensitizing dye having an absorption maximum in a wavelength range from 750 to 1,400 nm includes an infrared adsorbing agent. As the infrared absorbing agent, compounds described in Paragraph Nos. [0058] to [0087] of JP-A-2008-195018 can be used.

Of the compounds, a cyanine dye, a squarylium dye, a pyrylium dye and a nickel thiolate complex are particularly preferred. As the particularly preferred example of the compound, a cyanine dye represented by formula (a) shown below is exemplified.

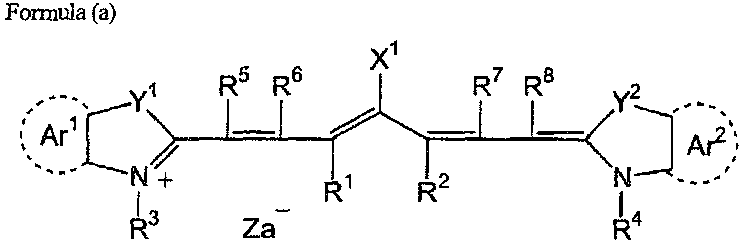

In formula (a), X¹ represents a hydrogen atom, a halogen atom, -N(R⁹)(R¹⁰), -X²-L¹ or a group represented by formula (b) shown below. R⁹ and R¹⁰, which may be the same or different, each represents an aromatic hydrocarbon group having from 6 to 10 carbon atoms which may have a substituent, an alkyl group having from 1 to 8 carbon atoms which may have a substituent or a hydrogen atom, or R⁹ and R¹⁰ may be combined with each other to form a ring. Among them, a phenyl group is preferred. X² represents an oxygen atom or a sulfur atom, L¹ represents a hydrocarbon group having from 1 to 12 carbon atoms, an aromatic ring group containing a hetero atom or a hydrocarbon group having from 1 to 12 carbon atoms and containing a hetero atom. The hetero atom as used herein indicates a nitrogen atom, a sulfur atom, an oxygen atom, a halogen atom or a selenium atom. In the group represented by formula (b) shown below, Xa⁻ has the same meaning as Za⁻ defined hereinafter, and R^{a} represents a hydrogen atom or a substituent selected from an alkyl group, an aryl group, a substituted or unsubstituted amino group and a halogen atom.

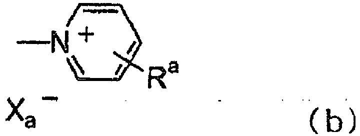

R¹ and R² each independently represents a hydrocarbon group having from 1 to 12 carbon atoms. In view of the preservation stability of a coating solution for image-recording layer, it is preferred that R¹ and R² each represents a hydrocarbon group having two or more carbon atoms. It is particularly preferred that R¹ and R² are combined with each other to form a 5-membered or 6-membered ring.

Ar¹ and Ar², which may be the same or different, each represents an aromatic hydrocarbon group which may have a substituent. Preferred examples of the aromatic hydrocarbon group include a benzene ring group and a naphthalene ring group. Also, preferred examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms which may have a substituent Preferred examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. In view of the availability of raw materials, a hydrogen atom is preferred Za⁻ represents a counter anion. However, Za⁻ is not necessary when the cyanine dye represented by formula (a) has an anionic substituent in the structure thereof and neutralization of charge is not needed. In view of the preservation stability of a coating solution for image-recording layer, preferred examples of the counter ion for Za⁻ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion.

Specific examples of the cyanine dye represented by formula (a) which can be preferably used in the invention include those described in Paragraph Nos. [0017] to [0019] of JP-A-2001-133969, Paragraph Nos. [0012] to [0021] of JP-A-2002-23360 and Paragraph Nos. [0012] to [0037] of JP-A-2002-40638.

The infrared absorbing agents may be used only one kind or in combination of two or more kinds thereof and it may also be used together with an infrared absorbing agent, for example, a pigment. As the pigment, compounds described in Paragraph Nos. [0072] to [0076] of JP-A-2008-195018 are preferred.

The content of the sensitizing dye in the image-recording layer according to the invention is preferably from 0.1 to 10.0% by weight, more preferably from 0.5 to 5.0% by weight, based on the total solid content of the image-recording layer.

### (E) Organic borate compound

The image-recording layer according to the invention preferably contains an organic borate compound. By incorporating the organic borate compound into the image-recording layer, the effects of the invention are accelerated. The organic borate compound (E) which can be used in the invention is not particularly restricted as long as it has a boron anion structure and is preferably a borate compound having a structure represented by formula (IV) shown below.

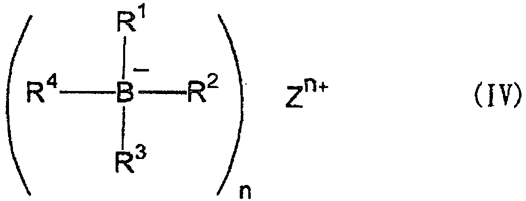

In formula (IV), R¹ to R⁴ each independently represents a monovalent organic group, Zⁿ⁺ represents an n-valent cation, and n represents an integer from 1 to 6.

The monovalent organic group represented by any one of R¹ to R⁴ includes, for example, an alkyl group, an alkenyl group, an aryl group, an alkynyl group and a cycloalkyl group, and is preferably an aryl group. The monovalent organic group may have a substituent and examples of the substituent capable of being introduced include an alkyl group, a halogenated alkyl group, an alkenyl group, an alkynyl group, an aryl group, a halogen atom, an alkoxy group, an alkoxycarbonyl group, an amino group, a cyano group, an amido group, a urethane group, a sulfo group, a thioalkoxy group and a carboxyl group.

Of the compounds, compounds wherein R¹ to R⁴ each represents an aryl group are preferred, and the aryl group having an electron withdrawing group as the substituent is more preferred. R¹ to R⁴ may be the same or different from each other.

The electron withdrawing group introduced into the aryl group is preferably a halogen atom or a fluoroalkyl group, and particularly preferably a fluorine atom or a trifluoromethyl group.

Zⁿ⁺ may be used without restriction as long as it is a cation capable of neutralizing the boron anion. Examples of the cation preferably used include an alkali metal ion, an alkaline earth metal ion, and an onium salt, for example, a sulfonium salt, an iodonium salt, an azinium salt, an ammonium salt, a phosphonium salt or a diazonium salt. From the standpoint of development property, an ion of alkali metal, for example, L1, Na or K is preferred

Examples of the organic borate compound (E) preferably used in the invention are set forth below, but the invention should not be construed as being limited thereto.

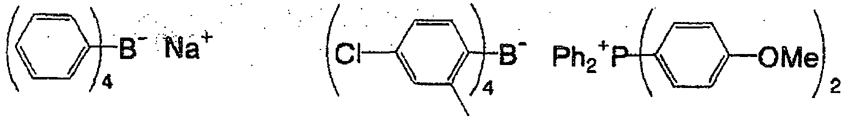

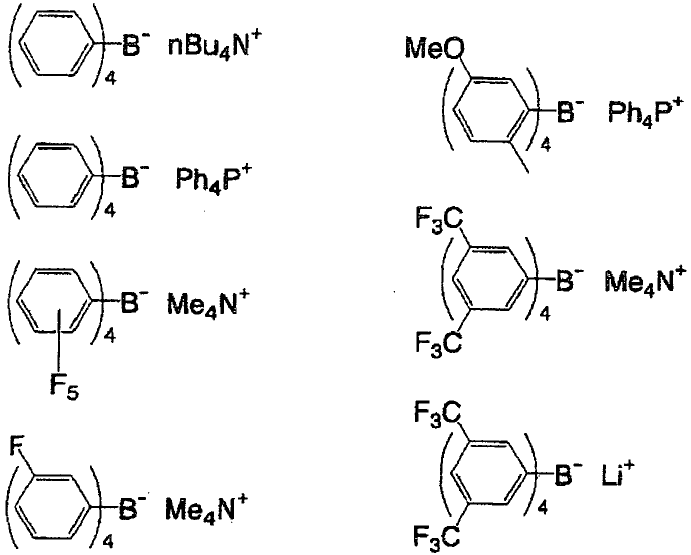

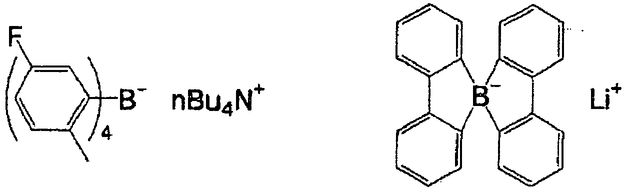

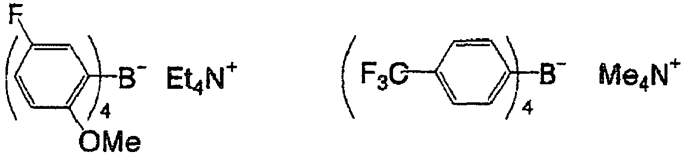

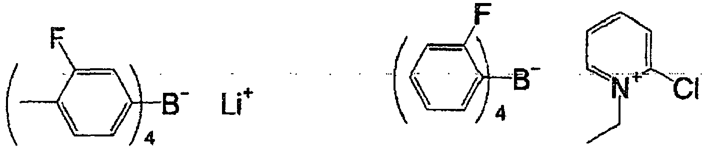

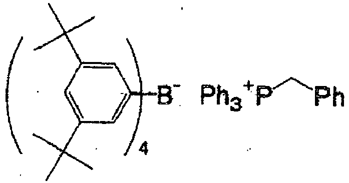

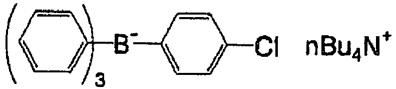

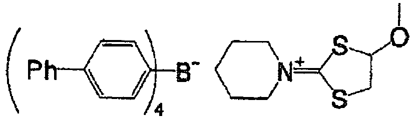

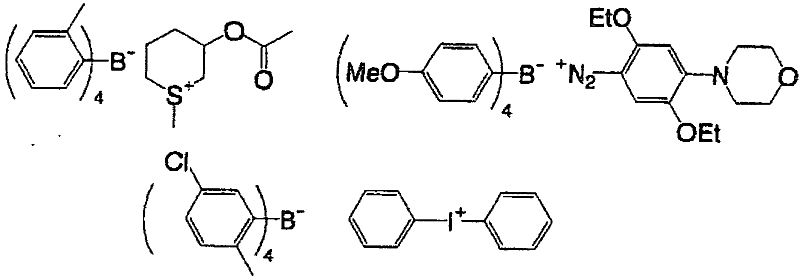

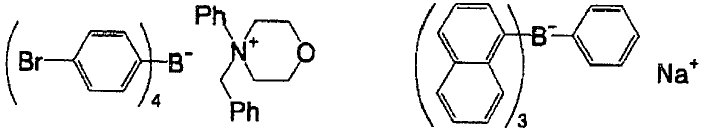

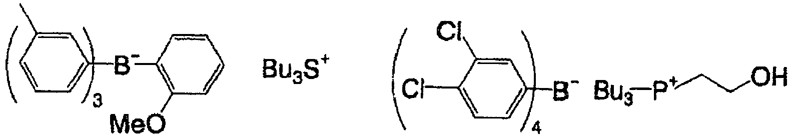

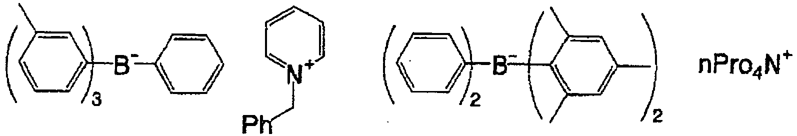

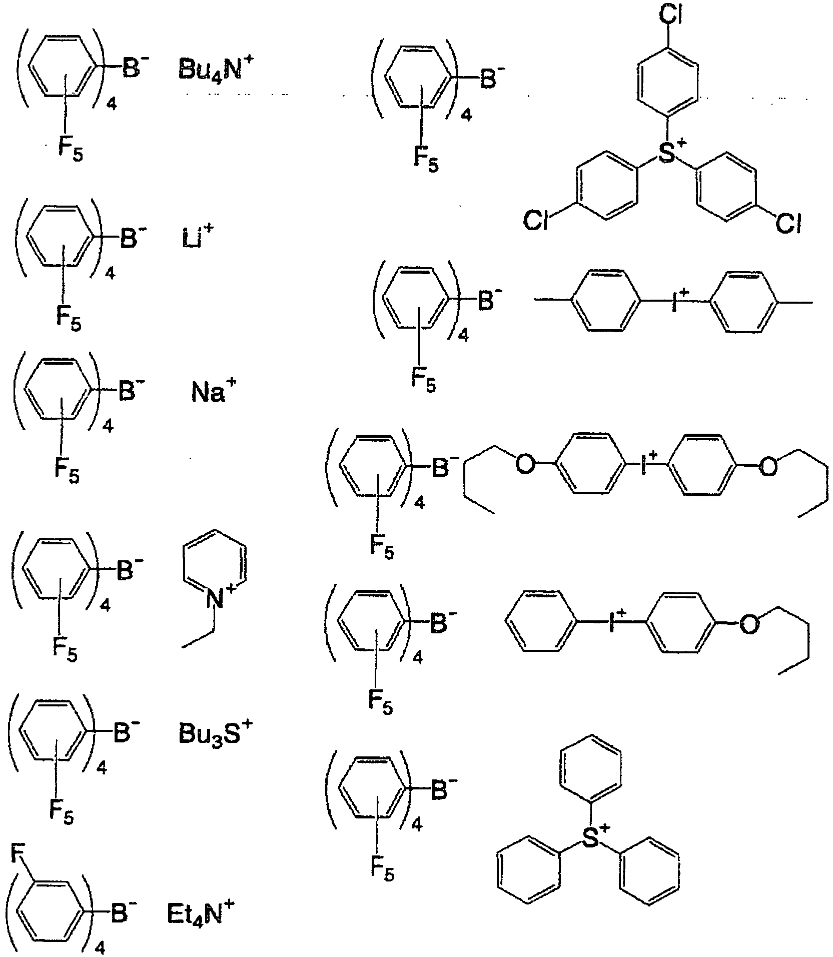

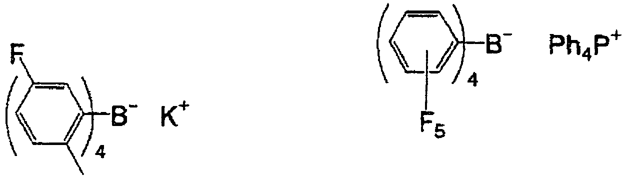

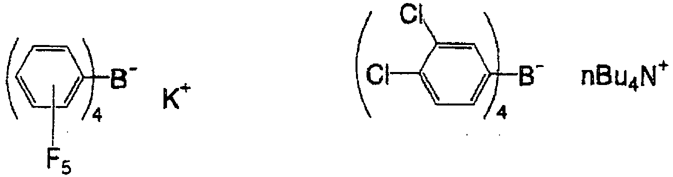

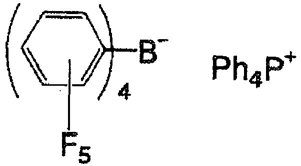

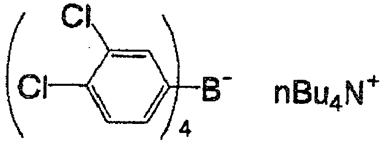

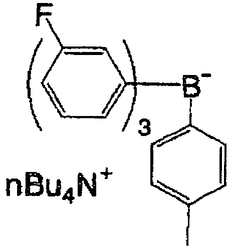

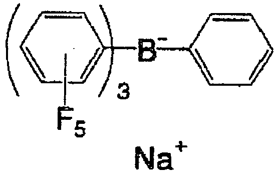

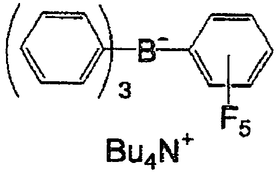

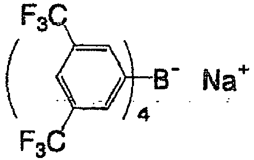

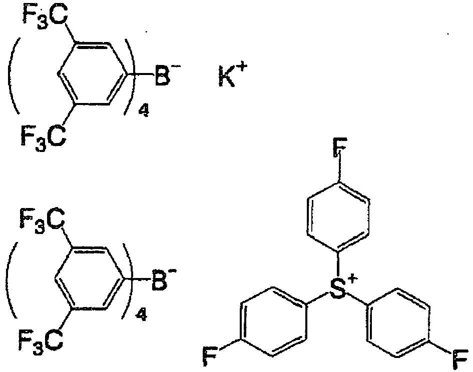

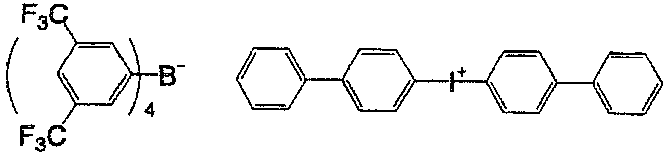

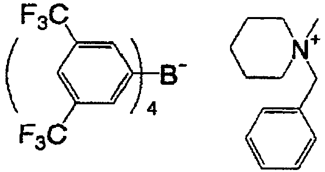

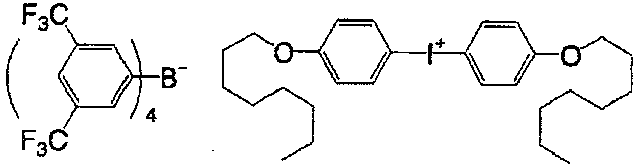

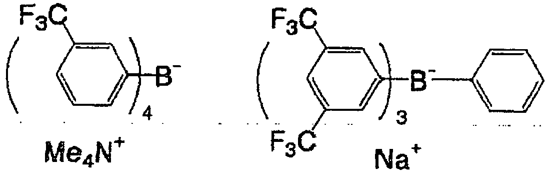

The content of the organic borate compound (E) in the image-recording layer according to the invention is preferably from 0.1 to 20% by weight, more preferably from 1 to 10% by weight, calculated in terms of solid content, from the standpoint of film-forming property.

### (F) Binder polymer

In the image-recording layer according to the invention, a binder polymer can be used for the purpose of improving film strength of the image-recording layer. The binder polymer which can be used in the invention can be selected from those heretofore known without restriction, and a polymer having a film-forming property is preferred. Among them, an acrylic resin, a polyvinyl acetal resin or a polyurethane resin is preferred.

As the binder polymer preferred for the invention, a polymer having a crosslinkable functional group for improving film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth)acryl group, a vinyl group or an allyl group or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable group in the binder polymer is preferably from 0.1 to 10.0 mmol, more preferably from 1.0 to 7.0 mmol, most preferably from 2.0 to 5.5 mmol, based on 1 g of the binder polymer.

It is also preferred that the binder polymer for use in the invention further contains a hydrophilic group. The hydrophilic group contributes to impart the on-press development property to the image-recording layer. In particular, coexistence of the crosslinkable group and the hydrophilic group makes it possible to maintain compatibility between the printing durability and development property.

The hydrophilic group includes, for example, a hydroxy group, a carboxyl group, an alkylene oxide structure, an amino group, an ammonium group, an amido bond, a sulfo group and a phosphoric acid group. Among them, an alkylene oxide structure containing from 1 to 9 alkylene oxide units having 2 or 3 carbon atoms is preferred. In particular, a polyethylene oxide structure containing from 2 to 8 ethylene oxide units is preferred. This improves ink receptivity. In order to introduce a hydrophilic group into the binder polymer, a monomer having the hydrophilic group may be copolymerized.

In order to control the ink receptivity, an oleophilic group, for example, an alkyl group, an aryl group, an aralkyl group or an alkenyl group may be introduced into the binder polymer according to the invention. Specifically, an oleophilic group-containing monomer, for example, an alkyl methacrylate may be copolymerized.

Specific examples (1) to (11) of the binder polymer for use in the invention are set forth below, but the invention should not be construed as being limited thereto. The ratio of the repeating units is indicated as a molar ratio.

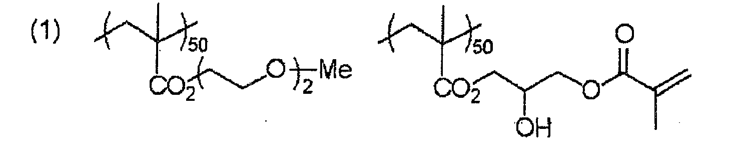

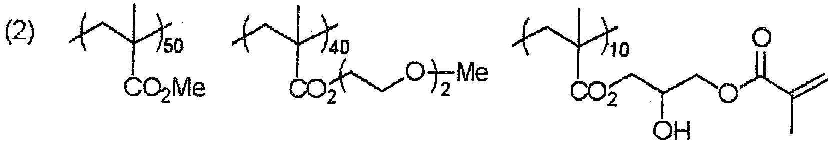

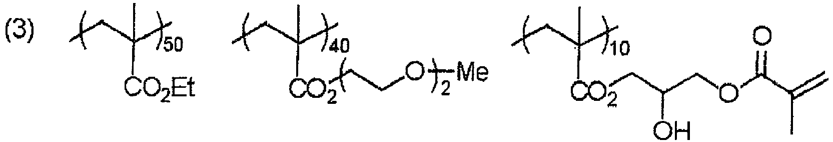

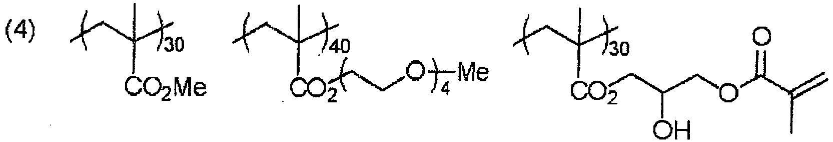

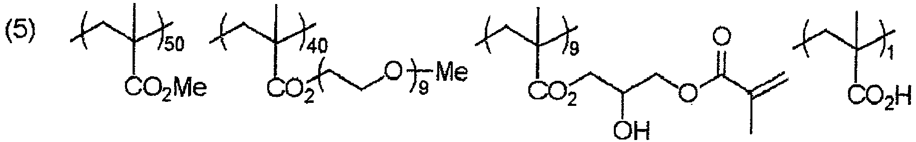

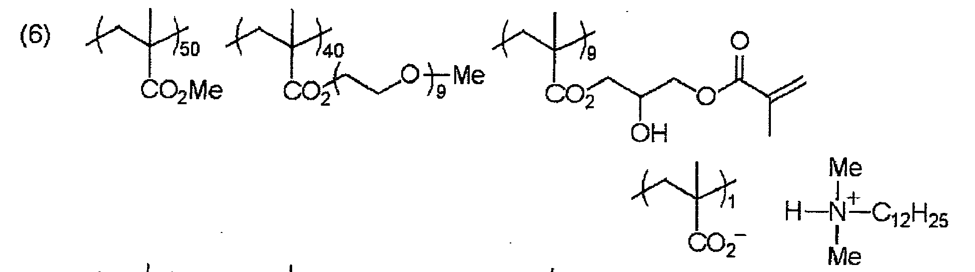

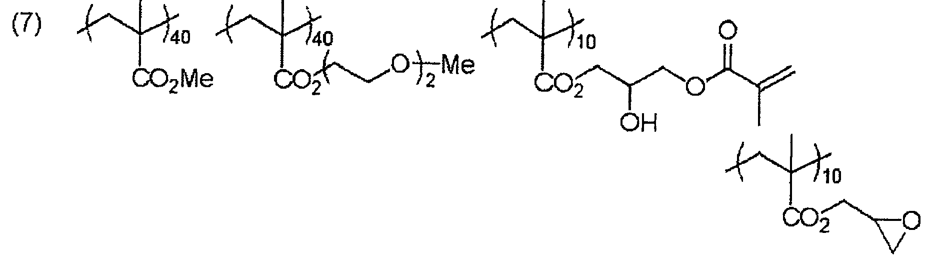

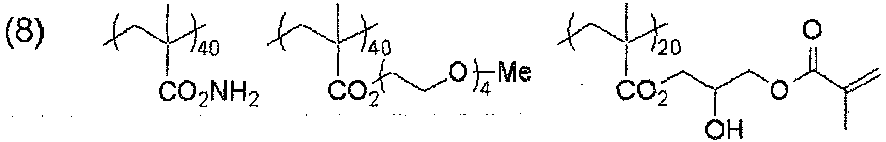

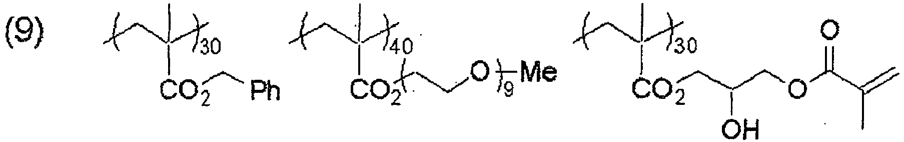

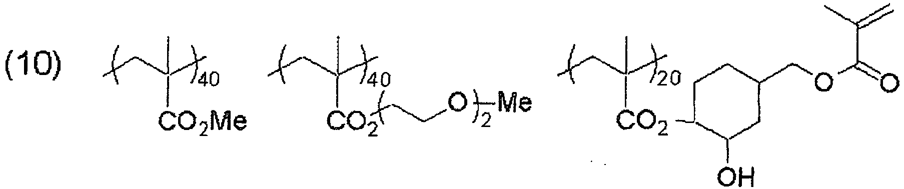

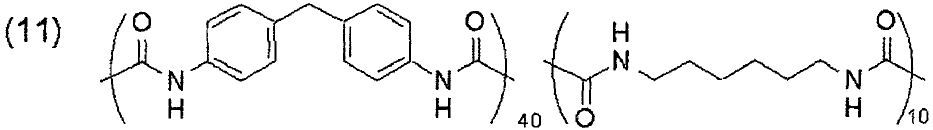

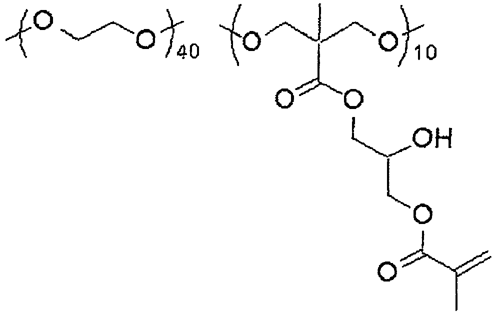

The weight average molecular weight (Mw) of the binder polymer according to the invention is preferably 2,000 or more, more preferably 5,000 or more, and still more preferably from 10,000 to 300,000.

According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.

The content of the binder polymer is ordinarily from 5 to 90% by weight, preferably from 5 to 80% by weight, more preferably from 10 to 70% by weight, based on the total solid content of the image-recording layer.

### (G) Polymer fine particle

According to the invention, a polymer fine particle can be used in order to improve the development property. In particular, a polymer fine particles having a polyalkylene oxide structure is preferred. Among them, a polymer fine particle having a polyalkylene oxide group in its side chain is preferred.

This increases permeability of dampening water to improve the development property. As the polyalkylene oxide structure, an alkylene oxide structure containing from 2 to 120 alkylene oxide units having 2 or 3 carbon atoms is preferred, and a polyethylene oxide structure containing from 2 to 120 ethylene oxide units is more preferred. Particularly, a polyethylene oxide structure containing from 20 to 100 ethylene oxide units is preferred. By means of such a polymer fine particle containing a polyalkylene oxide structure, compatibility between the printing durability and development property can be achieved. Also, the ink receptivity can be improved.

The polymer fine particle according to the invention is preferably a hydrophobilizing precursor capable of converting the image-recording layer to be hydrophobic when heat is applied. The hydrophobilizing precursor polymer fine particle is preferably at least one fine particle selected from a hydrophobic thermoplastic polymer fine particle, a thermo-reactive polymer fine particle, a microcapsule having a hydrophobic compound encapsulated and a microgel (crosslinked polymer fine particle). Among them, a polymer fine particle having a polymerizable group and a microgel are preferred. In order to improve the development property, the polymer fine particle preferably contains a polyalkylene oxide structure as described above.

As the hydrophobic thermoplastic polymer fine particle, hydrophobic thermoplastic polymer fine particles described, for example, in Research Disclosure, No. 33303, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile or polymethyl methacrylate is more preferred.

The average particle size of the hydrophobic thermoplastic polymer fine particle for use in the invention is preferably from 0.01 to 2.0 µm.

The thermo-reactive polymer fine particle for use in the invention includes a polymer fine particle having a thermo-reactive group and forms a hydrophobilized region by crosslinkage due to thermal reaction and change in the functional group involved therein.

As the thermo-reactive group of the polymer fine particle having a thermo-reactive group for use in the invention, a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an isocyanate group or a blocked form thereof, an epoxy group or a vinyloxy group performing an addition reaction and a functional group having an active hydrogen atom (for example, an amino group, a hydroxy group or a carboxyl group) as the reaction partner thereof a carboxyl group performing a condensation reaction and a hydroxy group or an amino group as the reaction partner thereof, and an acid anhydride performing a ring opening addition reaction and an amino group or a hydroxy group as the reaction partner thereof are preferably exemplified.

As the microcapsule for use in the invention, microcapsule having all or part of the constituting components of the image-recording layer encapsulated as described, for example, in JP-A-2001-277740 and JP-A-2001-277742 is exemplified. The constituting components of the image-recording layer may be present outside the microcapsule. It is a preferred embodiment of the image-recording layer containing microcapsule that hydrophobic constituting components are encapsulated in the microcapsule and hydrophilic constituting components are present outside the microcapsule.

The image-recording layer according to the invention may be an embodiment containing a crosslinked resin particle, that is, a microgel. The microgel can contain a part of the constituting components of the image-recording layer inside and/or on the surface thereof. Particularly, an embodiment of a reactive microgel containing the polymerizable compound (B) on the surface thereof is preferred from the standpoint of the image-forming sensitivity and printing durability.

As a method of microencapsulation or microgelation of the constituting components of the image-recording layer, known methods can be used.

The average particle size of the microcapsule or microgel is preferably from 0.01 to 3.0 µm, more preferably from 0.05 to 2.0 µm, and particularly preferably from 0.10 to 1.0 µm. In the range described above, good resolution and good time-lapse stability can be achieved.

The content of the polymer fine particle is preferably in a range from 5 to 90% by weight based on the total solid content of the image-recording layer.

### (H) Other components

The image-recording layer according to the invention may further contain other components, if desired.

### (1) Hydrophilic low molecular weight compound

The image-recording layer according to the invention may contain a hydrophilic low molecular weight compound in order to improve the development property without accompanying the decrease in the printing durability.

The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyhydroxy compound, e.g., glycerol, pentaerythritol or tris(2-hydroxyethyl) isocyanurate, an organic amine, e.g., triethanol amine, diethanol amine or monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.

According to the invention, it is preferred that at least one compound selected from a polyol, an organic sulfate, an organic sulfonate and a betaine is incorporated

Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; and an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphtyldisulfonate or trisodium 1,3,6-naphtyltrisulfonate. The salt may also be a potassium salt or a lithium salt

The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt

As the betaine, a compound wherein a number of carbon atoms included in a hydrocarbon substituent on the nitrogen atom is from I to 5 is preferred. Specific examples thereof include trimethylammonium acetate, dimethylpropylammonium acetate, 3-hydroxy-4-trimethylammoniobutyrate, 4-(1 -pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The amount of the hydrophilic low molecular weight compound added to the image-recording layer is preferably from 0.5 to 20% by weight, more preferably from 1 to 10% by weight, still more preferably from 2 to 10% by weight, based on the total solid content of the image-recording layer. In the range described above, good on-press development property and good printing durability are achieved.

The hydrophilic low molecular weight compounds may be used individually or as a mixture of two or more thereof.

### (2) Oil-sensitizing agent

In order to improve the ink receptivity, an oil-sensitizing agent, for example, a phosphonium compound, a nitrogen-containing low molecular weight compound or an ammonium group-containing polymer can be used in the image-recording layer according to the invention. In particular, in the case where an inorganic stratiform compound is incorporated into an overcoat layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate and benzyldimethyldodecylammonium hexafluorophosphate.

The ammonium group-containing polymer may be any polymer containing an ammonium group in its structure and is preferably a polymer containing from 5 to 80% by mole of (meth)acrylate having an ammonium group in its side chain as a copolymerization component.

As to the ammonium group-containing polymer, its reduced specific viscosity value (unit: ml/g) determined according to the measuring method described in JP-2009-208458 is preferably from 5 to 120, more preferably from 10 to 110, particularly preferably from 15 to 100. When the reduced specific viscosity value described above is calculated in terms of weight average molecular weight (Mw), from 10,000 to 150,000 is preferred, from 17,000 to 140,000 is more preferred, and 20,000 to 130,000 is particularly preferred.

Specific examples of the ammonium group-containing polymer are set forth below.
(1) 2-(Trimethylammonio)ethyl methacrylate p-toluenesulfonate/3,6-dioxaheptyl methacrylate copolymer (molar ratio: 10/90)
(2) 2-(Trimethylammonio)ethyl methacrylate hexafluorophosphate /3,6-dioxaheptyl methacrylate copolymer (molar ratio: 20/80)
(3) 2-(Ethyldimethylammonio)ethyl methacrylate p-toluenesulfonate/hexyl methacrylate copolymer (molar ratio: 30/70)
(4) 2-(Trimethylammonio)ethyl methacrylate hexafluorophosphate /2-ethylhexyl methacrylate copolymer (molar ratio: 20/80)
(5) 2-(Trimethylammonio)ethyl methacrylate methylsulfate/hexyl methacrylate copolymer (molar ratio: 40/60)
(6) 2-(Butyldimethylammonio)ethyl methacrylate hexafluorophosphate/3,6-dioxaheptyl methacrylate copolymer (molar ratio: 20/80)
(7) 2-(Butyldimethylammonio)ethyl acrylate hexafluorophosphate/3,6-dioxaheptyl methacrylate copolymer (molar ratio: 20/80)
(8) 2-(Butyldimethylammonio)ethyl methacrylate 13-ethyl-5,8,1 1-trioxa-1-heptadecanesulfonate/3,6-dioxaheptyl methacrylate copolymer (molar ratio: 20/80)
(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5)

The content of the oil-sensitizing agent is preferably from 0.01 to 30.0% by weight, more preferably from 0.1 to 15.0% by weight, still more preferably from 1 to 10% by weight, based on the total solid content of the image-recording layer.

### (3) Other components

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

### (I) Formation of image-recording layer

The image-recording layer according to the invention is formed by dispersing or dissolving each of the necessary components described above in a known solvent to prepare a coating solution and coating the solution on a support by a known method, for example, bar coater coating and drying as described, for example, in Paragraph Nos. [0142] to [0143] of JP-A-2008-195018. The coating amount (solid content) of the image-recording layer formed on the support after coating and drying may be varied according to the intended purpose but is in general preferably from 0.3 to 3.0 g/m². In the range described above, good sensitivity and good film properties of the image-recording layer can be achieved.

### [Undercoat layer]

In the lithographic printing plate precursor according to the invention, it is preferred to provide an undercoat layer (also referred to as an intermediate layer) between the image-recording layer and the support. The undercoat layer strengthens adhesion between the support and the image-recording layer in the exposed area and makes removal of the image-recording layer from the support in the unexposed area easy, thereby contributing improvement in the development property without accompanying degradation of the printing durability. Further, in the case of infrared laser exposure, since the undercoat layer acts as a heat insulating layer, decrease in sensitivity due to diffusion of heat generated upon the exposure into the support is prevented.

As a compound for use in the undercoat layer, specifically, for example, a silane coupling agent having an addition-polymerizable ethylenic double bond reactive group described in JP-A-10-282679 or a phosphorus compound having an ethylenic double bond reactive group described in JP-A-2-304441 is preferably exemplified. A polymer resin having an adsorbing group capable of adsorbing to a surface of the support, a hydrophilic group and a crosslinkable group as described in JP-A-2005-125749 and JP-A-2006-188038 is more preferably exemplified. The polymer resin is preferably a copolymer of a monomer having an adsorbing group, a monomer having a hydrophilic group and a monomer having a crosslinkable group. More specifically, a polymer resin which is a copolymer of a monomer having an adsorbing group, for example, a phenolic hydroxy group, a carboxyl group, -PO₃H₂, -OPO₃H₂, -CONHSO₂-, -SO₂NHSO₂- and -COCH₂COCH₃, a monomer having a hydrophilic sulfo group and a monomer having a polymerizable crosslinkable group, for example, a methacryl group or an allyl group. The polymer resin may contain a crosslinkable group introduced by a salt formation between a polar substituent of the polymer resin and a compound containing a substituent having a counter charge to the polar substituent of the polymer resin and an ethylenically unsaturated bond and also may be further copolymerized with a monomer other than those described above, preferably a hydrophilic monomer.

The content of the unsaturated double bond in the polymer resin for undercoat layer is preferably from 0.1 to 10.0 mmol, most preferably from 2.0 to 5.5 mmol, based on 1 g of the polymer resin.

The weight average molecular weight of the polymer resin for undercoat layer is preferably 5,000 or more, more preferably from 10,000 to 300,000.

The undercoat layer according to the invention may contain a chelating agent, a secondary or tertiary amine, a polymerization inhibitor or a compound containing an amino group or a functional group having polymerization inhibition ability and a group capable of interacting with the surface of aluminum support (for example, 1,4-diazobicyclo[22,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compounds for the undercoat layer described above in order to prevent the occurrence of stain due to the lapse of time.

The undercoat layer is coated according to a known method. The coating amount (solid content) of the undercoat layer is preferably from 0.1 to 100 mg/m², and more preferably from 1 to 30 mg/m².

### [Protective layer]

In the lithographic printing plate precursor according to the invention, it is preferred to provide a protective layer (overcoat layer) on the image-recording layer. The protective layer has a function for preventing, for example, occurrence of scratch in the image-recording layer or ablation caused by exposure with a high illuminance laser beam, in addition to the function for restraining an inhibition reaction against the image formation by means of oxygen blocking.

With respect to the protective layer having such properties, there are described, for example, in U.S. Patent 3,458,311 and JP-B-55549729 (the term "JP-B" as used herein means an "examined Japanese patent Publication"). As a polymer having low oxygen permeability for use in the protective layer, any water-soluble polymer and water-insoluble polymer can be appropriately selected to use. The polymers may be used in mixture of two or more thereof if desired. Specifically, for example, polyvinyl alcohol, a modified polyvinyl alcohol, polyvinyl pyrrolidone, a water-soluble cellulose derivative and poly(meth)acrylonitrile are exemplified.

As the modified polyvinyl alcohol, an acid-modified polyvinyl alcohol having a carboxyl group or a sulfo group is preferably used. Specifically, modified polyvinyl alcohols described in JP-A-2005-250216 and JP-A-2006-259137 are preferably exemplified.

It is also preferred for the protective layer to contain an inorganic stratiform compound, for example, natural mica or synthetic mica as described in JP-A-2005-119273 in order to increase the oxygen blocking property.

Further, the protective layer may contain a known additive, for example, a plasticizer for imparting flexibility, a surfactant for improving a coating property or a fine inorganic particle for controlling a surface slipping property. The oil-sensitizing agent described with respect to the image-recording layer may also be incorporated into the protective layer.

The adhesion property of the protective layer to the image-recording layer and scratch resistance are also extremely important in view of handling of the lithographic printing plate precursor. Specifically, when a hydrophilic protective layer comprising a water-soluble polymer is laminated on the oleophilic image-recording layer, layer peeling due to an insufficient adhesion property is liable to occur, and the peeled portion causes such a defect as failure in curing of the image-recording layer due to polymerization inhibition by oxygen. Various proposals have been made for improving the adhesion property between the image-recording layer and the protective layer. For example, it is described in JP-B-54-12215 and BP-A-1303578 that a sufficient adhesion property can be obtained by mixing from 20 to 60% by weight of an acryl-based emulsion or a water-insoluble vinyl pyrrolidone/vinyl acetate copolymer in the protective layer. Any of these known techniques can be applied to the protective layer according to the invention.

As to a coating method of the protective layer, known methods described, for example, in U.S. Patent 3,458,311 and JP-B-55-49729 are used. The coating amount of the protective layer is preferably in a range from 0.01 to 10 g/m², more preferably in a range from 0.02 to 3 g/m², most preferably in a range from 0.02 to 1 g/m², in terms of the coating amount after drying.

### [Support]

As the support for use in the lithographic printing plate precursor according to the invention, a known support is employed. Particularly, an aluminum plate subjected to roughening treatment and anodizing treatment according to a known method is preferred

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 µm.

The support may have a backcoat layer containing an organic polymer compound described in JP-A-5-45885 or an alkoxy compound of silicon described in JP-A-6-35174, provided on the back surface thereof, if desired.

### [Plate making method]

The lithographic printing plate precursor according to the invention is subjected to plate making by development processing after image exposure. The development processing is preferably conducted by on-press development or development using a developer having pH from 2 to 11. The plate making method is described in more detail below.

### <Image exposure>

The lithographic printing plate precursor is, for example, exposed with laser through a transparent original having a line image, a halftone dot image or the like, or imagewise exposed by scanning of laser beam based on digital data.

The wavelength of the exposure light source preferably used is from 300 to 450 nm or from 750 to 1,400 nm. In case of using the exposure light source from 300 to 450 nm, the lithographic printing plate precursor having an image-recording layer containing a sensitizing dye having an absorption maximum in such a wavelength range is preferably used. In case of using the exposure light source from 750 to 1,400 nm, the lithographic printing plate precursor having an image-recording layer containing an infrared absorbing agent which is a sensitizing dye having an absorption maximum in such a wavelength range is preferably used. As the light source having a wavelength from 300 to 450 nm, a semiconductor laser is preferably used. As the light source having a wavelength from 750 to 1,400 nm, a solid laser or semiconductor laser emitting an infrared ray is preferably used. With respect to the infrared ray laser, the output is preferably 100 mW or more, the exposure time per pixel is preferably within 20 microseconds, and the irradiation energy is preferably from 10 to 300 mJ/cm². Further, in order to shorten the exposure time, it is preferred to use a multibeam laser device. The exposure mechanism may be any of an internal drum system, an external drum system and a flat bed system.

The image exposure can be performed in a conventional manner using, for example, a plate setter. In case of the on-press development, after the lithographic printing plate precursor is mounted on a printing machine, the image exposure may be performed on the printing machine. As the light source used for the image exposure in the invention, a laser is preferred. The laser for use in the invention is not particularly restricted and preferably includes, for example, a solid laser or semiconductor laser emitting an infrared ray having a wavelength from 760 to 1,200 nm.

With respect to the infrared ray laser, the output is preferably 100 mW or more, the exposure time per pixel is preferably within 20 microseconds, and the irradiation energy is preferably from 10 to 300 mJ/cm². With respect to the laser exposure, in order to shorten the exposure time, it is preferred to use a multibeam laser device.

### <On-press development method>

In the on-press development method, the exposed lithographic printing plate precursor is mounted as it is on a printing machine without undergoing a development processing process. Then, the printing operation is initiated using the printing machine with supplying printing ink and dampening water and at an early stage of the printing the image-recording layer in the unexposed area is removed and the hydrophilic surface of support is revealed therewith to form the non-image area. In the exposed area of the image-recording layer, the image-recording layer cured by the exposure forms an ink receptive area having an oleophilic surface. As a result, the dampening water adheres onto the revealed hydrophilic surface and the printing ink adheres onto the exposed area of the image-recording layer, whereby printing is initiated.

While either the dampening water or printing ink may be supplied at first on the surface of lithographic printing plate precursor, it is preferred to supply the dampening water at first from the standpoint that the permeation of dampening water into the uncured image-recording layer is not inhibited by the printing ink.

Thus, the lithographic printing plate precursor according to the invention is subjected to the on-press development on an offset printing machine and used as it is for printing a large number of sheets.

### <Development using developer having pH from 2 to 11 >

According to a conventional developing process using an alkali developer, an overcoat layer is removed in a pre-water washing step, the alkali development is conducted, the alkali is removed by washing with water in a post-water washing step, gum solution treatment is conducted and drying is conducted in a drying step. However, in the case where the lithographic printing-plate precursor according to the invention is developed using a developer having pH from 2 to 11, the overcoat layer and the unexposed area of the image-recording layer are removed together and the resulting lithographic printing plate can be immediately mounted on a printing machine to perform printing. The developer having pH from 2 to 11 makes it possible to conduct the development and the gum solution treatment at the same time by incorporating a surfactant and/or a water-soluble polymer of oil-desensitizing property into the developer. Thus, the post-water washing step conducted after the alkali development is not particularly necessary and after conducting the development and gum solution treatment with one solution, the drying can be performed. It is preferred that after the development and gum treatment, the excess developer is removed using a squeeze roller, followed by conducting drying. Specifically, it is possible to perform a considerably simplified processing process (gum development) of development/gum treatment with one solution and drying.

The development according to the invention is performed in a conventional manner at temperature from 0 to 60°C, preferably from 15 to 40°C, using, for example, a method wherein the imagewise exposed lithographic printing plate precursor is immersed in the developer and rubbed with a brush or a method wherein the developer is sprayed to the imagewise exposed lithographic printing plate precursor and the lithographic printing plate precursor is rubbed with a brush.

The developer having pH from 2 to 11 is preferably an aqueous solution containing water as a main component (containing 60% by weight or more of water based on weight of the developer). In particular, an aqueous solution containing a surfactant (for example, an anionic, nonionic, cationic or amphoteric surfactant) or an aqueous solution containing a water-soluble polymer is preferred. An aqueous solution containing both the surfactant and the water-soluble polymer is also preferred. The pH of the developer is more preferably from 5 to 10.7, still more preferably from 6 to 10.5, and most preferably from 7.5 to 10.3.

The anionic surfactant for use in the developer is not particularly restricted and includes fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer is not particularly restricted, and conventionally known cationic surfactants can be used. Examples of the cationic surfactant include alkylamine salts, quaternary ammonium salts, alkylimidazolinium salts, polyoxyethylene alkyl amine salts and polyethylene polyamine derivatives.

The nonionic surfactant for use in the developer is not particularly restricted and includes polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol or sorbitan, fatty acid esters of sucrose, alkyl ethers of polyhydric alcohols and fatty acid amides of alkanolamines. Of the compounds, those having an aromatic ring and an ethylene oxide chain are preferred, and an alkyl-substituted or unsubstituted phenol ethylene oxide adduct and an alkyl-substituted or unsubstituted naphthol ethylene oxide adduct are more preferred.

The amphoteric surfactant for use in the developer is not particularly restricted and includes an amine oxide type, for example, alkyldimethylamine oxide, a betaine type, for example, alkyl betaine and an amino acid type, for example, sodium salt of alkylamino fatty acid. In Particular, an alkyldimethylamine oxide which may have a substituent, an alkyl carboxy betaine which may have a substituent and an alkyl sulfo betaine which may have a substituent are preferably used. Specific examples of the compound are described, for example, in Paragraph Nos. [0255] to [0278] of JP-A-2008-203359 and Paragraph Nos. [0028] to [0052] of JP-A-2008-276166. Specific examples of the more preferred compound include 2-alkyl-N-carboxymethyl-N-hydroxyethyl imidazolinium betaine, alkyldiaminoethylglycine hydrochloride, lauryldimethylaminoacetic acid betaine, N-lauric acid amidopropyldimethyl betaine and N-lauric acid amidopropyldimethylamine oxide.

Two or more kinds of the surfactants may be used in combination. The rate of the surfactant contained in the developer is preferably from 0.01 to 20% by weight, and more preferably from 0.1 to 10% by weight.

The water-soluble polymer for use in the developer having pH from 2 to 11 includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used. For example, as a commercially available product, SOYAFIVE (trade name, produced by Fuji Oil Co., Ltd.) is available and various grade products can be used. The soybean polysaccharide preferably used is that having viscosity in a range from 10 to 100 mPa/sec in the aqueous 10% by weight solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more kinds of the water-soluble polymers may be used in combination. The content of the water-soluble polymer in the developer is preferably from 0.1 to 20% by weight, and more preferably from 0.5 to 10% by weight.

Into the developer having pH from 2 to 11 for use in the invention, a pH buffer agent may further be incorporated.

As the pH buffer agent, a pH buffer agent exhibiting a pH buffer function at pH from 2 to 11 is used without particular restriction In the invention, a weak alkaline buffer agent is preferably used and includes, for example, (a) a carbonate ion and a hydrogen carbonate ion, (b) a borate ion, (c) a water-soluble amine compound and an ion of the water-soluble amine compound, and combinations thereof. Specifically, for example, (a) a combination of a carbonate ion and a hydrogen carbonate ion, (b) a borate ion, or (c) a combination of a water-soluble organic amine compound and an ion of the water-soluble amine compound exhibits a pH buffer function in the developer to prevent fluctuation of the pH even when the developer is used for a long period of time and as a result, for example, the deterioration of development property resulting from the fluctuation of pH and the occurrence of development scum are restrained. The combination of a carbonate ion and a hydrogen carbonate ion is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually or in combination of two or more thereof

When the combination (a) of a carbonate ion and a hydrogen carbonate ion is adopted as the pH buffer agent, the total amount of the carbonate ion and hydrogen carbonate ion in the developer is preferably from 0.05 to 5 mole/l, more preferably from 0.1 to 2 mole/l, particularly preferably from 0.2 to 1 mole/l.

The developer may contain an organic solvent. As the organic solvent capable of being contained, for example, an aliphatic hydrocarbon (e.g., hexane, heptane, ISOPAR E, ISOPAR H, ISOPAR G (produced by Esso Chemical Co., Ltd.)), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide or N-methylpyrrolidone).

Two or more kinds of the organic solvents may be used together in the developer.

Further, when the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer having pH from 2 to 11 may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer can be used as a developer and a development replenisher for the exposed lithographic printing plate precursor and it is preferably applied to an automatic processor described hereinafter. In the case of conducting the development processing using an automatic processor, the processing solution becomes fatigued in accordance with the processing amount, and hence the processing ability may be restored using a replenisher or a fresh developer.

The development processing using the developer having pH from 2 to 11 according to the invention is preferably performed by an automatic processor equipped with a supplying means for the developer and a rubbing member. An automatic processor using a notating brush roll as the rubbing member is particularly preferred. Further, the automatic processor is preferably provided with a means for removing the excess developer, for example, a squeeze roller or a drying means, for example, a hot air apparatus, subsequently to the development processing means.

Further, in the plate making process of preparing a lithographic printing plate from the lithographic printing plate precursor according to the invention, the lithographic printing plate precursor may be heated its entire surface before or during the exposure or between the exposure and the development, if desired. By the heating, the image-forming reaction in the image-recording layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development Ordinarily, the heating before the development is preferably performed under a mild condition of 150°C or lower. When the temperature is too high, a problem may arise, for example, in that the unexposed area is cured. On the other hand, the heating after the development can be performed using very strong conditions. Ordinarily, the heat treatment is carried out in a temperature range from 100 to 500°C. When the temperature is too low, a sufficient effect of strengthening the image may not be obtained, and whereas when it is excessively high, problems of deterioration of the support and thermal decomposition of the image area may occur.

### EXAMPLES

The present invention will be described in detail with reference to the following examples, but the invention should not be construed as being limited thereto. With respect to polymer compound, unless otherwise specified, a molecular weight of the polymer compound means a weight average molecular weight (Mw) and a ratio of repeating units is indicated as a mole percent.

### Examples 1 to 20 and Comparative Examples 1 to 5

### [1] Preparation of Lithographic printing plate precursors (1) to (20)

### (1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by immersing in a 25% by weight aqueous sodium hydroxide solution of 45°C for 9 seconds, washed with water, then immersed in a 20% by weight nitric acid solution at 60°C for 20 seconds, and washed with water. The etching amount of the grained surface was about 3 g/m².

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current, and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying.

The plate was then subjected to an anodizing treatment using as an electrolytic solution, a 15% by weight aqueous sulfuric acid solution (containing 0.5% by weight of aluminum ion) at a current density of 15 A/dm² to form a direct current anodized film of 2.5 g/m², washed with water and dried to prepare Support (1).

Thereafter, in order to ensure the hydrophilicity of the non-image area, Support (1) was subjected to silicate treatment using a 2.5% by weight aqueous sodium silicate No. 3 solution at 60°C for 10 seconds and then was washed with water to obtain Support (2). The adhesion amount of Si was 10 mg/m². The center line average roughness (Ra) of the support was measured using a stylus having a diameter of 2 µm and found to be 0.51 µm.

### (2) Formation of Undercoat layer

Coating solution (1) for undercoat layer shown below was coated on Support (2) described above so as to have a dry coating amount of 20 mg/m² to prepare a support having an undercoat layer.

### <Coating solution (1) for undercoat layer>

| | |
|---|---|
| Compound (1) for undercoat layer having structure shown below | 0.18 g |
| Hydroacyethyliminodiacetic acid | 0.10 g |
| Methanol | 55.24 g |
| Water | 6.15 g |

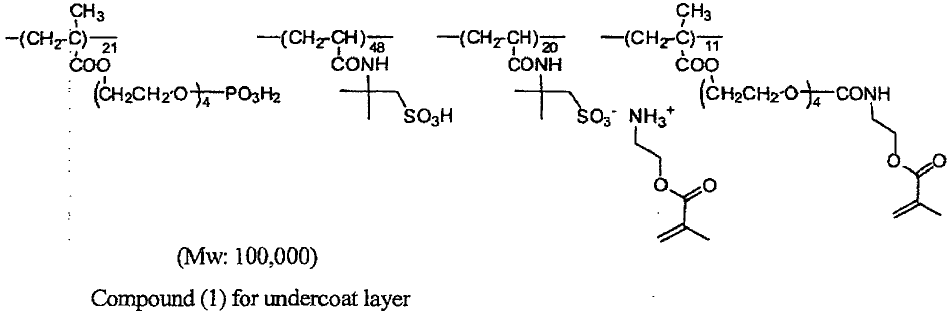

### (3) Formation of Image-recording layer

Coating solution (A) for image-recording layer shown below was coated on the support having the undercoat layer described above by a bar and dried in an oven at 70°C for 60 seconds to form an image-recording layer having a dry coating amount of 0.6 g/m², thereby preparing Lithographic printing plate precursors (1) to (20), respectively.

### <Coating solution (A) for image-recording layer>

| | |
|---|---|
| Aqueous dispersion (1) of polymer fine particle | 20.0 g |
| Infrared absorbing agent (1) having structure shown below | 0.2g |
| Radical generator (IRGACURE 250, produced by BASF) | 0.5 g |
| RAFT agent shown in Table 1 | Amount shown in Table 1 |
| Polymerizable compound (SR-399, produced by Sartomer Co.) | 1.50 g |
| Mercapto-3-triazole | 0.2 g |
| BYK 336 (produced by BYK-Chemie GmbH) | 0.4 g |
| KLUCEL M (produced by Hercules Chemical Co., Inc.) | 4.8 g |
| ELVACITE 4026 (produced by Ineos Acrylics Inc.) | 2.5 g |
| n-Propanol | 55.0 g |
| 2-Butanone | 17.0 g |

The compounds indicated using their trade names in the composition described above are shown below.

### IRGACURE 250: (4-methylphenyl)[4-(2-methylpropyl)phenyl]iodonium hexafluorophosphate (75% by weight propylene carbonate solution)

SR-399: Dipentaerythritol pentaacrylate
BYK 336: Modified dimethylpolysiloxane copolymer (25% by weight xylene/methoxypropyl acetate solution)
KLUCEL M: Hydroxypropyl cellulose (2% by weight aqueous solution)
ELVACITE 4026: Highly branched polymethyl methacrylate (10% by weight 2-butanone solution)

The numeral in the column of RAFT agent of Table 1 indicates the number of the compound described hereinbefore.

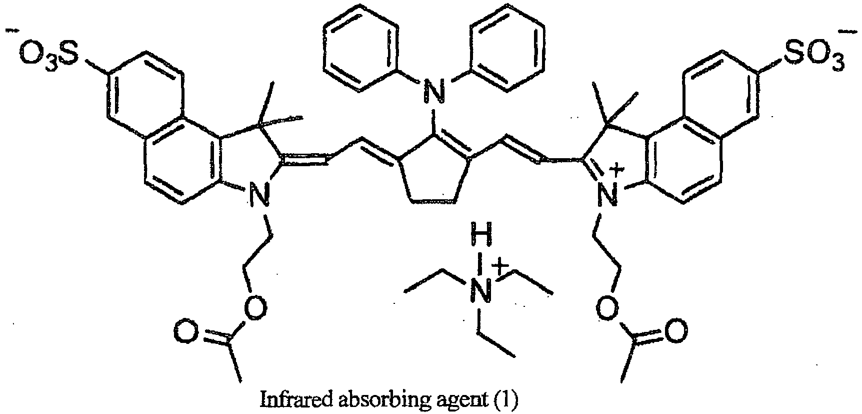

### (Preparation of Aqueous dispersion (1) of polymer fine particle)

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average repeating unit number of ethylene glycol: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2,2'-azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded to 98% or more to obtain Aqueous dispersion (1) of polymer fine particle of PEGMA/St/AN (10/10/80 in a weight ratio). The particle size distribution of the polymer fine particle had the maximum value at the particle size of 150 nm.

The particle size distribution was determined by taking an electron microphotograph of the polymer fine particle, measuring particle sizes of 5,000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

### [II] Preparation of Lithographic printing plate precursor for Comparative Example 1

Lithographic printing plate precursor (R1) for Comparative Example 1 was prepared in the same manner as in the preparation of lithographic printing plate precursor described above except for not adding the RAFT agent in the preparation of lithographic printing plate precursor described above.

### [III] Preparation of Lithographic printing plate precursors for Comparative Examples 2 to 5

Lithographic printing plate precursors (R2) to (R5) for Comparative Examples 2 to 5 were prepared in the same manner as the preparation of Lithographic printing plate precursor (1) for Example 1 except for adding the comparative compounds (known chain transfer agents) shown in Table 1 in place of the RAFT agent in Coating solution (A) for image-recording layer described above, respectively.

The structures of the comparative compounds are shown below.

### Comparative compounds (chain transfer agents described in JP-A-2007-52332)

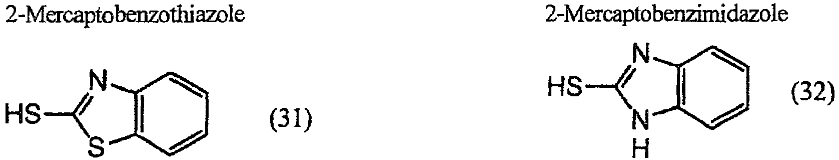

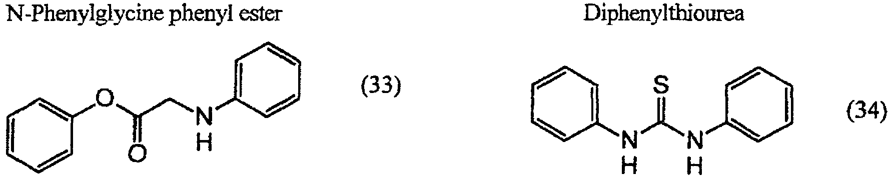

The lithographic printing plate precursor obtained was exposed by LUXEL PLATESETTER T-6000III equipped with an infrared semiconductor laser (produced by FUJIFILM Corp.) under the conditions of a rotational number of an external drum of 400 rpm, laser output of 85% (plate surface energy of 300 mJ/cm²) and resolution of 2,400 dpi. The exposed image contained a solid image and a halftone dot chart of AM 200 lines (50%, 80%, 85%, 90%, 92%, 95%, 97%, 99%).

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (by volume ratio)) and FUSION-G (N) Black Ink (produced by DIC Graphics Corp.), the dampening water and ink were supplied according to the standard automatic printing start method of LITHRONE 26 to conduct printing on 100 sheets of TOKUBISHI art paper (76.5 kg) at a printing speed of 10,000 sheets per hour.

Missing of halftone dot in shadow area (tone reproducibility) and printing durability were evaluated in the manner described below.

### (1) Missing of halftone dot in shadow area (tone reproducibility)

As to the 100th printed material described above, a halftone dot area ratio in the shadow area (80%, 85%, 90%, 92%, 95%, 97%, 99%) of halftone dot chart of AM 200 lines was measured using a halftone dot % measuring machine iCPlate II. Comparing an original halftone dot % with the halftone dot % measured on the printed material and a halftone dot % range where the original halftone dot % was equal to the halftone dot % measured on the printed material was determined to evaluate an acceptable range of the missing of halftone dot in shadow area. The broader the acceptable range of the missing of halftone dot in shadow area, the better the tone reproducibility.

### (2) Printing durability

After performing the evaluation for the tone reproducibility described above, the printing was continued. As the increase in a number of printing papers, the image-recording layer was gradually abraded to cause decrease in the ink density on the printed material. A number of printing papers wherein a value obtained by measuring a halftone dot area ratio of the 50% halftone dot of AM screen on the printed material using a Gretag densitometer decreased by 5% from the value measured on the 100th printed material was determined to evaluate the printing durability.

**TABLE 1: Comparative Examples 1 to 5 and Examples 1 to 20**

| | Lithographic Printing Plate Precursor | RAFT Agent | | | Printing Durability (sheets) | Acceptable Range of Missing of Halftone Dot in Shadow Area |
|---|---|---|---|---|---|---|
| | | Kind | Amount Added | Amount Ratio to Radical Generator | | |
| Comparative Example 1 | (R1) | None | None | - | 60,000 | To 85% |
| Comparative Example 2 | (R2) | Comparative Compound 31 | 0.025g | 5% | 30,000 | To 95% |
| Comparative Example 3 | (R3) | Comparative Compound 32 | 0.025 g | 5% | 30,000 | To 95% |
| Comparative Example 4 | (R4) | Comparative Compound 33 | 0.025 g | 5% | 30,000 | To 95% |
| Comparative Example 5 | (R5) | Comparative Compound 34 | 0.025 g | 5% | 30,000 | To 95% |
| Example 1 | (1) | Compound 10 | 0.025 g | 5% | 60,000 | To 92% |
| Example 2 | (2) | Compound 11 | 0.025 g | 5% | 60,000 | To 92% |
| Example 3 | (3) | Compound 1 | 0.025 g | 5% | 60,000 | To 95% |
| Example 4 | (4) | Compound 14 | 0.025 g | 5% | 60,000 | To 95% |
| Example 5 | (5) | Compound 5 | 0.025 g | 5% | 60,000 | To 95% |
| Example 6 | (6) | Compound 3 | 0.025 g | 5% | 60,000 | To 99% |
| Example 7 | (7) | Compound 13 | 0.025 g | 5% | 60,000 | To 99% |
| Examples 8 | (8) | Compound 19 | 0.025 g | 5% | 60,000 | To 99% |
| Example 9 | (9) | Compound 20 | 0.025 g | 5% | 60,000 | To 99% |
| Example 10 | (10) | Compound 26 | 0.025 g | 5% | 60,000 | To 99% |
| Example 11 | (11) | Compound 12 | 0.025 g | 5% | 60,000 | To 99% |
| Example 12 | (12) | Compound 16 | 0.025 g | 5% | 60,000 | To 99% |
| Example 13 | (13) | Compound 8 | 0.025 g | 5% | 60,000 | To 99% |
| Example 14 | (14) | Compound 22 | 0.025 g | 5% | 60,000 | To 99% |
| Example 15 | (15) | Compound 13 | 0.005 g | 1% | 60,000 | To 99% |
| Example 16 | (16) | Compound 13 | 0.05 g | 10% | 60,000 | To 99% |
| Example 17 | (17) | Compound 13 | 2.5 mg | 0.5% | 60,000 | To 95% |
| Example 18 | (18) | Compound 13 | 0.1 g | 20% | 50,000 | To 99% |
| Example 19 | (19) | Compound 13 | 0.05 mg | 0.01% | 60,000 | To 92% |
| Example 20 | (20) | Compound 13 | 0.15 g | 30% | 40,000 | To 99% |

### Example 21 and Comparative Example 6

Lithographic printing plate precursor (21) for Example 21 was prepared in the same manner as in the preparation of Lithographic printing plate precursor (1) described above except for using Coating solution (B) for image-recording layer shown below in place of Coating solution (A) for image-recording layer.

Also, Lithographic printing plate precursor (R6) for Comparative Example 6 was prepared in the same manner as in the preparation of Lithographic printing plate precursor (21) except for not adding the RAFT agent used in Coating solution (B) for image-recording layer.

### <Coating solution (B) for image-recording layer>

| | |
|---|---|
| Aqueous dispersion (1) of polymer fine particle | 20.0 g |
| Infrared absorbing agent (1) having structure shown above | 0.2g |
| Radical generator (IRGACURE 250, produced by BASF) | 0.5 g |
| RAFT agent shown in Table 2 | 0.025 g |
| Polymerizable compound (SR-399, produced by Sartomer Co.) | 1.50 g |
| Mercapto-3-triazole | 0.2 g |
| BYK 336 (produced by BYK-Chemie GmbH) | 0.4 g |
| KLUCEL M (produced by Hercules Chemical Co., Inc.) | 4.8 g |
| ELVACITE 4026 (produced by Ineos Acrylics Inc.) | 2.5 g |
| n-Propanol | 55.0 g |
| 2-Butanone | 17.0 g |
| Tetraphenyl borate | 0.25 g |

The lithographic printing plate precursor obtained was evaluated in the same manner as in Example 1 and the results obtained are shown in Table 2. In Table 2, the results of Example 7 and Comparative Example 1 are also described for the comparison.

**TABLE 2: Example 21 and Comparative Example 6**

| | Lithographic Printing Plate Precursor | RAFT Agent | Presence or Absence of Borate Compound | Printing Durability (sheets) | Acceptable Range of Missing of Halftone Dot in Shadow Area |
|---|---|---|---|---|---|
| Comparative Example 1 | (R1) | None | Absence | 60,000 | To 85% |
| Comparative Example 6 | (R6) | None | Presence | 100,000 | To 80% |
| Example 7 | (7) | Compound 13 | Absence | 60,000 | To 99% |
| Example 21 | (21) | Compound 13 | Presence | 100,000 | To 99% |

### Example 22

Coating solution (1) for protective layer having the composition shown below was further coated on the image-recording layer of Lithographic printing plate precursor (21) by a bar and dried in an oven at 120°C for 60 seconds to form a protective layer having a dry coating amount of 0.15 g/m², thereby preparing Lithographic printing plate precursor (22).

### <Coating solution (1) for protective layer>

| | |
|---|---|
| Dispersion (1) of inorganic stratiform compound shown below | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 6.0 g |

### (Preparation of Dispersion (1) of inorganic stratiform compound)

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 µm. The aspect ratio of the inorganic particle thus-dispersed was 100 or more.

Lithographic printing plate precursor (22) obtained was evaluated in the same manner as in Example 1 and the results obtained are shown in Table 3.

### Example 23

Lithographic printing plate precursor (23) was prepared in the same manner as in the preparation of Lithographic printing plate precursor (22) except for not adding the tetraphenyl borate in the image-recording layer of Lithographic printing plate precursor (22).

The evaluation of tone reproducibility and printing durability of Lithographic printing plate precursor (23) obtained was conducted in the same manner as in Example 1 except for changing the exposure by LUXEL PLATESETTER T-6000III under the conditions of a rotational number of an external drum of 400 rpm and laser output of 85% (plate surface energy of 300 mJ/cm²) to the conditions of a rotational number of an external drum of 1,000 rpm and laser output of 70% (plate surface energy of 100 mJ/cm²). The results obtained are shown in Table 3.

### Example 24

Example 24 was conducted in the same manner as in Example 22 using Lithographic printing plate precursor (22) same as in Example 22 except for changing the exposure conditions to the conditions of a rotational number of an external drum of 1,000 rpm and laser output of 70% (plate surface energy of 100 mJ/cm²). The results obtained are shown in Table 3.

### Comparative Example 7

Lithographic printing plate precursor (R7) for comparison was prepared in the same manner as in the preparation of Lithographic printing plate precursor (22) except for not adding the RAFT agent used in the image-recording layer of Lithographic printing plate precursor (22).

The evaluation of Lithographic printing plate precursor (R7) was conducted under the same condition as in Example 23 and the results obtained are shown in Table 3. In Table 3, the results of Example 7, Example 21 and Comparative Example 1 are also described for the comparison.

**TABLE 3: Examples 22 to 24 and Comparative Example 7**

| | Lithographic Printing Plate Precursor | RAFT Agent | Presence or Absence of Borate Compound | Presence or Absence of Protective Layer | Printing Durability (sheets) | Acceptable Range of Missing of Halftone Dot in Shadow Area | Exposure Amount (mJ/cm²) |
|---|---|---|---|---|---|---|---|
| Comparative Example 1 | (R1) | None | Absence | Absence | 60,000 | To 85% | 300 |
| Comparative Example 7 | (R7) | None | Presence | Presence | 100,000 | To 85% | 100 |
| Example 7 | (7) | Compound 13 | Absence | Absence | 60,000 | To 99% | 300 |
| Example 21 | (21) | Compound 13 | Presence | Absence | 100,000 | To 99% | 300 |
| Example 22 | (22) | Compound 13 | Presence | Presence | 120,000 | To 99% | 300 |
| Example 23 | (23) | Compound 13 | Absence | Presence | 80,000 | To 99% | 100 |
| Example 24 | (22) | Compound 13 | Presence | Presence | 100,000 | To 99% | 100 |

### Examples 25 to 36

### [1] Preparation of Lithographic printing plate precursors (25) to (36)

### (1) Formation of Image-recording layer

Coating solution (C) for image-recording layer having the composition shown below was coated on the undercoat layer formed as described above by a bar and dried in an oven at 100°C for 60 seconds to form an image-recording layer having a dry coating amount of 1.0 g/m².

Coating solution (C) for image-recording layer was prepared by mixing Photosensitive liquid (1) shown below with Microgel liquid (1) shown below just before the coating, followed by stirring.

### <Photosensitive liquid (1)>

| | |
|---|---|
| Binder polymer (1) having structure shown below | 0.240 g |
| Infrared absorbing agent (2) having structure shown below | 0.030 g |
| Radical generator (1) having structure shown below | 0.162 g |
| Polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.050 g |
| Oil-sensitizing agent (Phosphonium compound (1) having structure shown below) | 0.055 g |
| Oil-sensitizing agent (Benzyl dimethyl octyl ammonium PF₆ salt | 0.018 g |
| Oil-sensitizing agent (Ammonium group-containing polymer having structure shown below (reduced specific viscosity: 44 ml/g) | 0.035 g |
| Fluorine-based surfactant (1) having structure shown below | 0.008 g |
| 2-Butanone | 1.091 g |
| 1-Methoxy-2-propanol | 8.609 g |
| RAFT agent shown in Table 4 | 0.010 g |

### <Microgel liquid (1)>

| | |
|---|---|
| Microgel (1) shown below | 2.640 g |
| Distilled water | 2.425 g |

The structures of Binder polymer (1), Infrared absorbing agent (2), Radical generator (1), Phosphonium compound (1), Hydrophilic low molecular weight compound (1), Ammonium group-containing polymer and Fluorine-based surfactant (1) are shown below.

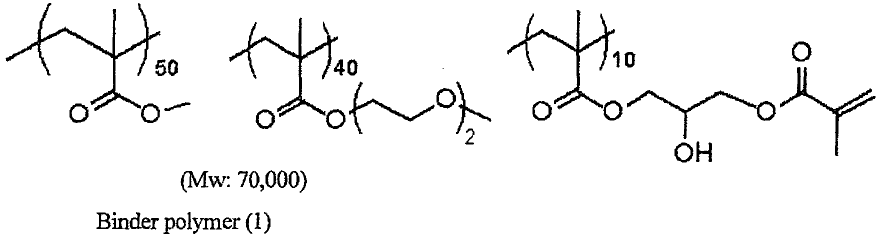

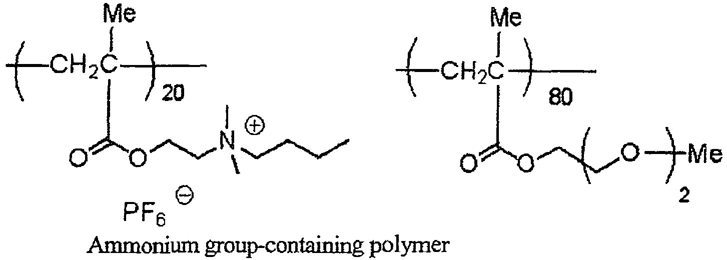

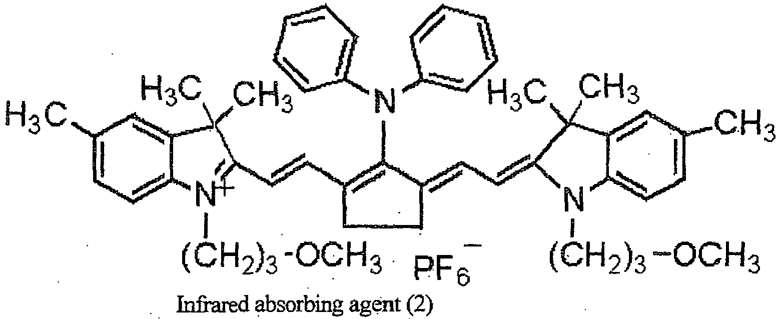

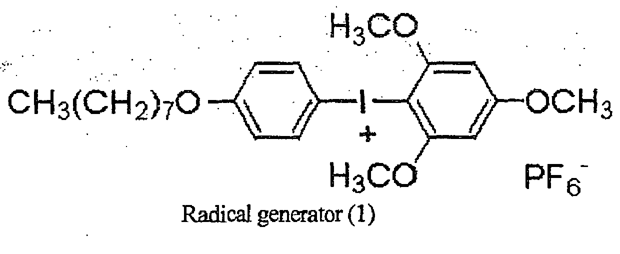

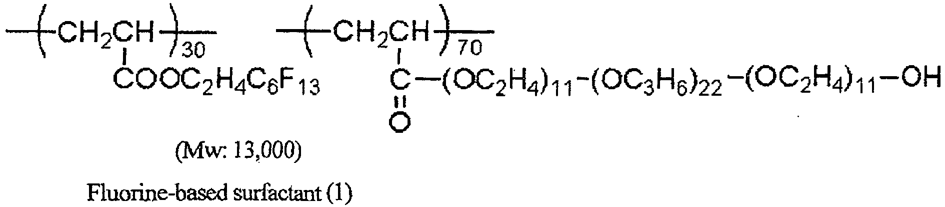

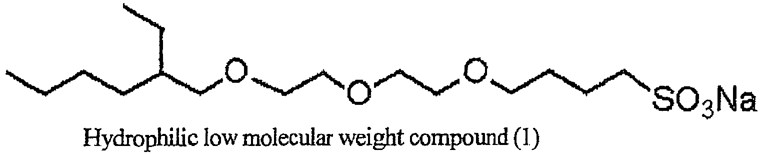

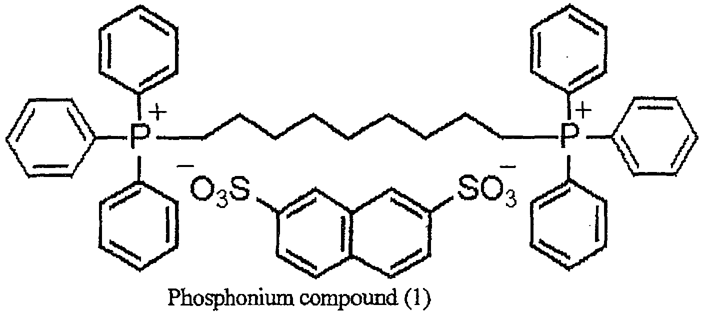

### <Preparation of Microgel (1)>

An oil phase component was prepared by dissolving 4.46 g of polyfunctional isocyanate having the structure shown below (produced by Mitsui Chemicals Polyurethane, Inc., 75% ethyl acetate solution), 0.86 g of adduct obtained by addition of trimethylolpropane (6 mol) and xylene diisocyanate (18 mol) and further addition of methyl-terminated polyoxyethylene (1 mol) (number of oxyethylene repeating unit: 90) (produced by Mitsui Chemicals Polyurethane, Inc., 50% ethyl acetate solution), 1.72 g of pentaerythritol tetraacrylate (SR399E, produced by Sartomer Co.) and 0.05 g of PIONIN A-41C (produced by Takemoto Oil & Fat Co., Ltd., 70% methanol solution) in 4.46 g of ethyl acetate. The oil phase component and 17.30 g of water as an aqueous phase component were mixed and emulsified using a homogenizer at 10,000 rpm for 15 minutes. The resulting emulsion was stirred at 40°C for 4 hours. The microgel liquid thus-obtained was diluted using water so as to have the solid content concentration of 21.8% by weight The average particle size of the microgel was 0.25 µm.

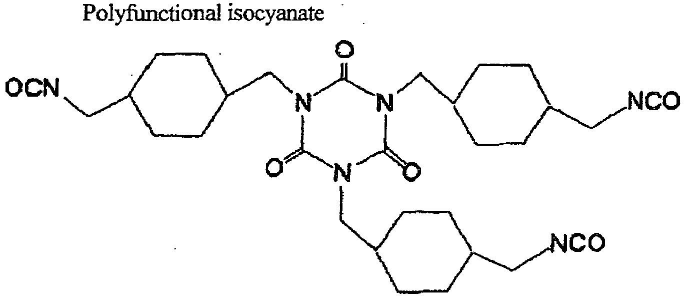

### (2) Formation of protective layer

Coating solution (1) for protective layer having the composition shown above was further coated on the image-recording layer described above by a bar and dried in an oven at 120°C for 60 seconds to form a protective layer having a dry coating amount of 0.15 g/m², thereby preparing Lithographic printing plate precursors (25) to (36), respectively.

### Comparative Example 8

Lithographic printing plate precursor (R8) for Comparative Example 8 was prepared in the same manner as in the preparation of Lithographic printing plate precursor (25) except for not adding the RAFT agent used in Photosensitive liquid (1).

### Comparative Example 9

Lithographic printing plate precursor (R9) for Comparative Example 9 was prepared in the same manner as in the preparation of Lithographic printing plate precursor (25) except for using the same amount of Comparative Compound (35) shown below in place of the RAFT agent in Photosensitive liquid (1).

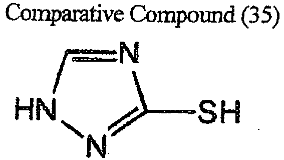

### [II] Evaluation of Lithographic printing plate precursor

Lithographic printing plate precursors (25) to (36), (R8) and (9) obtained were subjected to the on-press development and the tone reproducibility and printing durability were evaluated in the same manner as in Example 23. The results obtained are shown in Table 4.

**TABLE 4: Examples 25 to 36 and Comparative Examples 8 and 9**

| | Lithographic Printing Plate Precursor | RAFT Agent | Presence or Absence of Borate Compound | Presence or Absence of Protective Layer | Printing Curability (sheets) | Acceptable Range of Missing of Halftone Dot in Shadow Area | Exposure Amount (mJ/cm²) |
|---|---|---|---|---|---|---|---|
| Comparative Example 8 | (R8) | None | Absence | Presence | 80,000 | To 90% | 100 |
| Comparative Example 9 | (R9) | Comparative Compound 35 | Absence | Presence | 80,000 | To 90% | 100 |
| Example 25 | (25) | Compound 10 | Absence | Presence | 80,000 | To 92% | 100 |
| Example 26 | (26) | Compound 11 | Absence | Presence | 80,000 | To 92% | 100 |
| Example 27 | (27) | Compound 1 | Absence | Presence | 80,000 | To 95% | 100 |
| Example 28 | (28) | Compound 14 | Absence | Presence | 80,000 | To 95% | 100 |
| Examples 29 | (29) | Compound 3 | Absence | Presence | 80,000 | To 99% | 100 |
| Example 30 | (30) | Compound 13 | Absence | Presence | 80,000 | To 99% | 100 |
| Example 31 | (31) | Compound 19 | Absence | Presence | 80,000 | To 99% | 100 |
| Example 32 | (32) | Compound 20 | Absence | Presence | 80,000 | To 99% | 100 |
| Example 33 | (33) | Compound 26 | Absence | Presence | 80,000 | To 99% | 100 |
| Example 34 | (34) | Compound 12 | Absence | Presence | 80,000 | To 99% | 100 |
| Example 35 | (35) | Compound 16 | Absence | Presence | 80,000 | To 99% | 100 |
| Example 36 | (36) | Compound 8 | Absence | Presence | 80,000 | To 99% | 100 |

### Example 37 and Comparative Example 10

### [1] Preparation of Lithographic printing plate precursor (37)

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The aluminum plate degreased was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The roughened aluminum plate desmut-treated was subjected to an anodizing treatment under condition of current density of 10 A/dm² and voltage of 15 V in an aqueous 15% by weight sulfuric acid solution at 25°C for one minute and then subjected to a hydrophilizing treatment using an aqueous 1% by weight polyvinylphosphonic acid solution at 75°C, thereby preparing a support. The surface roughness of the support was measured and found to be 0.44 µm (Ra indication according to JIS B 0601). The support thus-obtained was referred to as Support (3).

Coating solution (D) for image-recording layer having the composition shown below was coated on Support (3) so as to have a dry coating amount of 1.4 g/m² and dried at 100°C for one minute to form an image-recording layer.

### <Coating solution (D) for image-recording layer>

| | |
|---|---|
| Polymerizable compound (M-1) | 3.33 parts by weight |
| Binder polymer (B-1) (Mw: 47,000) | 2.67 parts by weight |
| Sensitizing dye (D-1) | 0.32 parts by weight |
| Radical generator (I-1) | 0.61 parts by weight |
| Chain transfer agent (S-2) | 0.57 parts by weight |
| N-Nitrosophenylhydroxylamine aluminum salt | 0.020 parts by weight |
| Dispersion of ε-phthalocyanine pigment | 0.71 parts by weight |
| [pigment: 15% by weight; dispersing agent (allyl | |
| methacrylate/methacrylic acid (molar ratio: 80/20) copolymer) | |
| (Mw: 60,000): 10% by weight; solvent (cyclohexanone/methoxypropyl acetate/1-methoxy-2-propanol = 15% by weight/20% by weight/40% by weight)] | |
| Fluorine-based nonionic surfactant (MEGAFAC F780F, produced by DIC Corp.) | 0.016 parts by weight |
| RAFT agent (Compound 15) | 0.06 parts by weight |
| 2-Butanone | 47 parts by weight |
| Propylene glycol monomethyl ether | 45 parts by weight |

### M-1

### Mixture of the compounds shown below

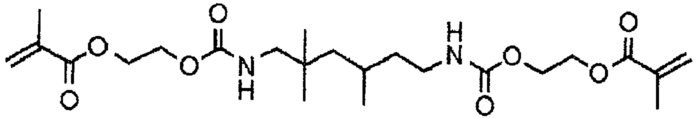

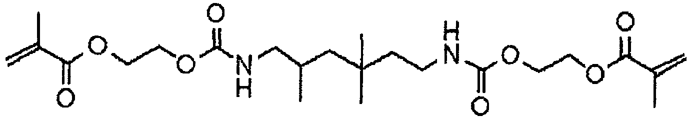

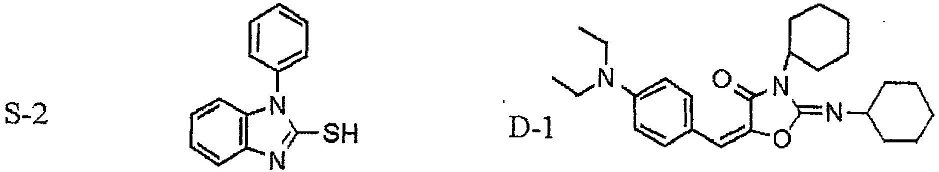

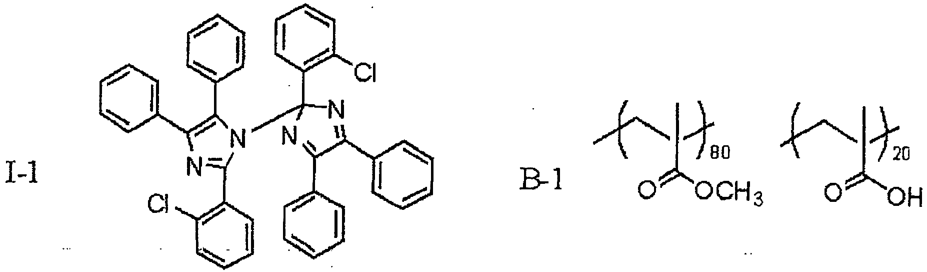

Coating solution (2) for protective layer shown below was coated on the image-recording layer using a bar so as to have a dry coating amount of 0.50 g/m² and dried at 125°C for 70 seconds to form a protective layer, thereby preparing Lithographic printing plate precursor (37).

### <Coating solution (2) for protective layer>

| | |
|---|---|
| Dispersion (2) of inorganic stratiform compound shown below | 0.6 g |
| Sulfonic acid-modified polyvinyl alcohol (GOSERAN CKS-50, produced by Nippon Synthetic Chemical Industry Co., Ltd. (saponification degree: 99% by mole; average polymerization degree: 300; modification degree: about 0.4% by mole)) | 0.8 g |
| Surfactant (EMALEX 710, produced by Nihon Emulsion Co., Ltd.) | 0.002 g |
| Water | 13 g |

### (Preparation of Dispersion (2) of inorganic stratiform compound)

In 368 g of ion-exchanged water was added 32 g of synthetic mica (SOMASIF ME-100, produced by CO-OP Chemical Co., Ltd; aspect ratio: 1,000 or more) and the mixture was dispersed using a homogenizer until the average particle diameter (measured by a laser scattering method) became 0.5 µm to obtain Dispersion (2) of inorganic stratiform compound.

### [II] Preparation of Lithographic printing plate precursor (R10)

Lithographic printing plate precursor (R10) for Comparative Example 10 was prepared in the same manner as in the preparation of Lithographic printing plate precursor (37) except for not adding the RAFT agent used in the image-recording layer of Lithographic printing plate precursor (37).

### [III] Exposure, Development, Printing and Evaluation of Lithographic printing plate precursor

### <Exposure>

Each of Lithographic printing plate precursors (37) and (R10) was subjected to image exposure by Violet semiconductor laser plate setter Vx9600 (having InGaN semiconductor laser (emission wavelength: 405 nm ± 10 nm/output: 30 mW)) produced by FUJIFILM Electronic Imaging Ltd. (FFEI). The image drawing was performed at resolution of 2,400 dpi using as the exposure image, a solid image and a halftone dot chart of AM 200 lines (50%, 80%, 85%, 90%, 92%, 95%, 97%, 99%) in a plate surface exposure amount of 0.07 mJ/cm² so as to have a halftone dot area ratio of 50%.

### <Development>

The exposed lithographic printing plate precursor was subjected to preheating at 100°C for 30 seconds and then subjected to development processing in an automatic development processor having a structure as shown in Fig. 1 using a developer having the composition shown below.

The automatic development processor comprises a developing unit 6 for developing a lithographic printing plate precursor (hereinafter, also referred to as a "PS plate") 4 and a drying unit 10 for drying the developed PS plate 4. An insertion slot is formed in a side plate of the automatic development processor (on the left side in Fig. 1) and the PS plate 4 inserted through the insertion slot is transported into the developing unit 6 by carrying-in rollers 16 provided inside the side plate of the automatic development processor. In a developing tank 20 of the developing unit 6, transport rollers 22, a brush roller 24 and squeeze rollers 26 are provided in order from the upstream side in the transporting direction and backup rollers 28 are disposed in appropriate positions therebetween. The PS plate 4 is immersed in the developer while being transported by the transport rollers 22 and the overcoat layer and the unexposed area of the image-recording layer of PS plate 4 were removed by rotation of the brush roller 24 to conduct development processing. The PS plate 4 subjected to the development processing is transported into the drying unit 10 by the squeeze rollers (carrying-out rollers) 26.

In the drying unit 10, a guide roller 36 and a pair of skewer rollers 38 are disposed in order from the upstream side in the transporting direction. In the drying unit 10, drying means, four example, hot air supply means or heat generating means (not shown) is also provided. A discharge slot is provided in the drying unit 10 and the PS plate 4 dried by the drying means is discharged through the discharge slot whereby the processing of PS plate by the automatic development processor is completed. The automatic development processor used in the example had one brush roller having an outer diameter of 50 mm and being implanted with fiber of polybutylene terephthalate (bristle diameter: 200 µm, bristle length: 17 µm), and the brush roller was rotated at 200 rpm (peripheral velocity at the tip of brush: 0.52 m/sec) in the same direction as the transporting direction of the lithographic printing plate precursor. The temperature of the developer was 30°C. The transportation of the lithographic printing plate precursor was conducted at transporting speed of 100 cm/min. After the development processing, the lithographic printing plate was dried in the drying unit. The drying temperature was 80°C.

### <Developer 1 (pH: 9.8)>

| | |
|---|---|
| Surfactant (W-1) shown below ((SOFTAZOLINE LPB-R, produced by Kawaken Fine Chemicals Co., Ltd.) | 15 g |
| Surfactant (W-2) shown below (SOFTAZOLINE LAO, Produced by Kawaken Fine Chemicals Co., Ltd) | 4 g |
| Chelating agent: Trisodium ethylenediaminesuccinate (OCTAQUEST E30, produced by Innospec Specialty Chemicals Inc.) | 0.68 g |
| 2-Bromo-2-nitropropane-1,3 -diol | 0.025 g |
| 2-Methyl-4-isothiazoline-3-one | 0.025 g |
| Silicone type deforming agent (TSA 739, produced by GE Toshiba Silicone Co., Ltd.) | 0.15 g |
| Sodium gluconate | 1.5 g |
| Sodium carbonate | 1.06 g |
| Sodium hydrogen carbonate | 0.52 g |
| Water | 77.04 g |

The pH was adjusted by adding sodium hydroxide and phosphoric acid to the developer having the composition described above.

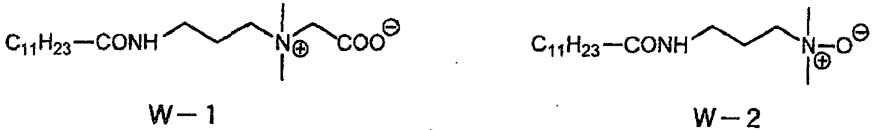

### <Printing>

The lithographic printing plate obtained was mounted on a printing machine (SOR-M, produced by Heidelberg) and printing was performed on sheets of TOKUBISHI art paper (76.5 kg) at a printing speed of 6,000 sheets per hour using dampening water (EU-3 (etching solution, produced by FUJIFILM Corp.))/water/isopropyl alcohol = 1/89/10 (by volume ratio)) and FUSION-G (N) Black Ink (produced by DIC Graphics Corp.).

### <Evaluation of Missing of halftone dot in shadow area (tone reproducibility)>

As to the 100th printed material, a halftone dot area ratio in the shadow area (70% or more) of halftone dot of AM 200 lines was measured using iCPlate II. Comparing an original halftone dot % with the halftone dot % measured on the printed material and a halftone dot % range where the original halftone dot % was equal to the halftone dot % measured on the printed material was determined as an acceptable range of the missing of halftone dot in shadow area to evaluate the tone reproducibility. The results obtained are shown in Table 5.

### <Evaluation of Printing durability>

After performing the evaluation for the tone reproducibility described above, the printing was continued. As the increase in a number of printing papers, the image-recording layer was gradually abraded to cause decrease in the ink density on the printed material. A number of printing papers wherein a value obtained by measuring a halftone dot area ratio of the 50% halftone dot of AM screen on the printed material using a Gretag densitometer decreased by 5% from the value measured on the 100th printed material was determined to evaluate the printing durability. The results obtained are shown in Table 5.

**TABLE 5: Example 37 and Comparative Example 10**

| | Lithographic Printing Plate Precursor | RAFT Agent | Presence or Absence of Borate Compound | Presence or Absence of Protective Layer | Printing Durability (sheets) | Acceptable Range of Missing of Halftone Dot in Shadow Area. | Exposure Amount (mJ/cm²) |
|---|---|---|---|---|---|---|---|
| Comparative Example 10 | (R10) | None | None | Presence | 140,000 | To 85% | 70 |
| Example 37 | (37) | Compound 13 | None | Presence | 140,000 | To 99% | 70 |

## Claims

1. A lithographic printing plate precursor comprising an image-recording layer and a support, wherein the image-recording layer comprises (A) a radical generator, (B) a polymerizable compound, (C) a reversible addition fragmentation chain transfer agent and (D) a sensitizing dye, wherein the reversible addition fragmentation chain transfer agent (C) is a compound represented by one of the following formulae (1), (2) and (3): 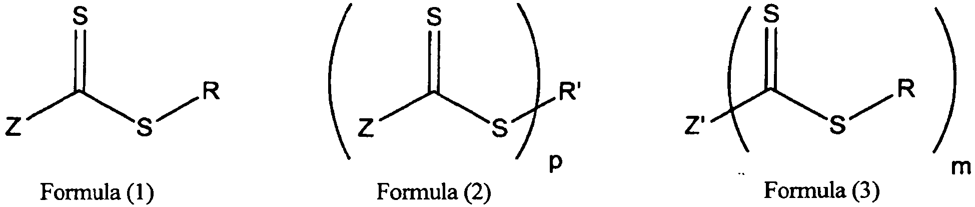 wherein Z represents a group selected from an alkyl group, an aryl group and an alkylthio group, and each of these groups may have a substituent, R represents a group selected from an alkyl group and an alkylthio group, and each of these groups may have a substituent, p represents an integer from 2 to 6, m represents an integer from 2 to 4, R' represents a p-valent connecting group composed of combination of the following structural units, and Z' represents an m-valent connecting group composed of at least one benzene ring:

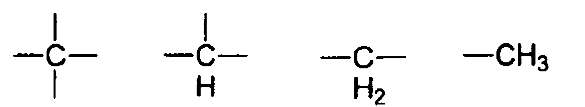

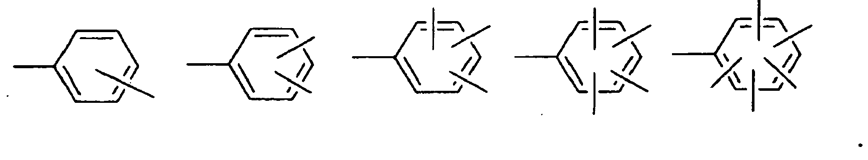

2. The lithographic printing plate precursor as claimed in Claim 1, wherein the reversible addition fragmentation chain transfer agent (C) is a compound represented by formula (2) or (3).

3. The lithographic printing plate precursor as claimed in Claim 1or 2, wherein a weight average molecular weight of the reversible addition fragmentation chain transfer agent (C) is 1,200 or less.

4. The lithographic printing plate precursor as claimed in any one of Claims 1 to 3, wherein the image-recording layer comprises (E) an organic borate compound.

5. The lithographic printing plate precursor as claimed in Claim 4, wherein the organic borate compound (E) is a tetraaryl borate.

6. The lithographic printing plate precursor as claimed in any one of Claims 1 to 5, which comprises a protective layer.

7. The lithographic printing plate precursor as claimed in any one of Claims 1 to 6, wherein the sensitizing dye (D) has an absorption maximum in a wavelength range from 350 to 450 nm.

8. The lithographic printing plate precursor as claimed in any one of Claims 1 to 6, wherein the sensitizing dye (D) has an absorption maximum in a wavelength range from 750 to 1,400 nm.

9. The lithographic printing plate precursor as claimed in any one of Claims 1 to 8, wherein the image-recording layer is an image-recording layer capable of forming an image by removing an unexposed area by supplying printing ink and dampening water on a printing machine after exposure.

## Patentansprüche

1. Lithographiedruckplattenvorläufer, umfassend eine Bildaufzeichnungsschicht und einen Träger, worin die Bildaufzeichnungsschicht (A) einen Radikalbildner, (B) eine polymerisierbare Verbindung, (C) ein reversibles Additions-Fragmentations-Kettenübertragungsmittel und (D) einen Sensibilisierungsfarbstoff umfasst, worin das reversible Additions-Fragmentations-Kettenübertragungsmittel (C) eine durch irgendeine der folgenden Formeln (1), (2) und (3) dargestellte Verbindung ist: 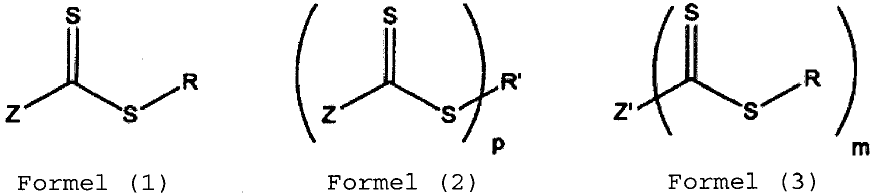 worin Z eine aus einer Alkylgruppe, einer Arylgruppe und einer Alkylthiogruppe ausgewählte Gruppe darstellt und jede dieser Gruppen einen Substituenten aufweisen kann, R eine aus einer Alkylgruppe und einer Alkylthiogruppe ausgewählte Gruppe darstellt und jede dieser Gruppen einen Substituenten aufweisen kann, p eine ganze Zahl von 2 bis 6 darstellt, m eine ganze Zahl von 2 bis 4 darstellt, R' eine p-valente Verknüpfungsgruppe darstellt, die aus einer Kombination der folgenden Struktureinheiten aufgebaut ist, und Z' eine m-valente Verknüpfungsgruppe darstellt, die aus mindestens einem Benzolring aufgebaut ist:

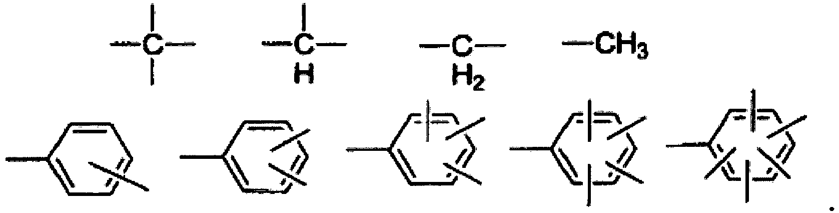

2. Lithographiedruckplattenvorläufer gemäß Anspruch 1, worin das reversible Additions-Fragmentations-Kettenübertragungsmittel (C) eine durch Formel (2) oder (3) dargestellte Verbindung ist.

3. Lithographiedruckplattenvorläufer gemäß Anspruch 1 oder 2, worin das gewichtsgemittelte Molekulargewicht des reversiblen Additions-Fragmentations-Kettenübertragungsmittels (C) 1.200 oder weniger beträgt.

4. Lithographiedruckplattenvorläufer gemäß irgendeinem der Ansprüche 1 bis 3, worin die Bildaufzeichnungsschicht (E) eine organische Boratverbindung umfasst.

5. Lithographiedruckplattenvorläufer gemäß Anspruch 4, worin die organische Boratverbindung (E) Tetraarylborat ist.

6. Lithographiedruckplattenvorläufer gemäß irgendeinem der Ansprüche 1 bis 5, welcher eine Schutzschicht umfasst.

7. Lithographiedruckplattenvorläufer gemäß irgendeinem der Ansprüche 1 bis 6, worin der Sensibilisierungsfarbstoff (D) ein Absorptionsmaximum im Wellenlängenbereich von 350 bis 450 nm aufweist.

8. Lithographiedruckplattenvorläufer gemäß irgendeinem der Ansprüche 1 bis 6, worin der Sensibilisierungsfarbstoff (D) ein Absorptionsmaximum im Wellenlängenbereich von 750 bis 1.400 nm aufweist.

9. Lithographiedruckplattenvorläufer gemäß irgendeinem der Ansprüche 1 bis 8, worin die Bildaufzeichnungsschicht eine Bildaufzeichnungsschicht ist, die in der Lage ist, durch Entfernen eines unbelichteten Bereichs durch Zuführen von Drucktinte und Anfeuchtwasser auf einer Druckmaschine nach der Belichtung ein Bild zu erzeugen.

## Revendications

1. Précurseur de plaque d'impression lithographique comprenant une couche d'impression d'image et un support, dans lequel la couche d'impression d'image comprend (A) un générateur de radicaux, (B) un composé polymérisable, (C) un agent de transfert de chaîne réversible par addition-fragmentation et (D) un colorant de sensibilisation, dans lequel l'agent de transfert de chaîne réversible par addition-fragmentation (C) est un composé représenté par l'une des formules (1), (2) et (3) suivantes : 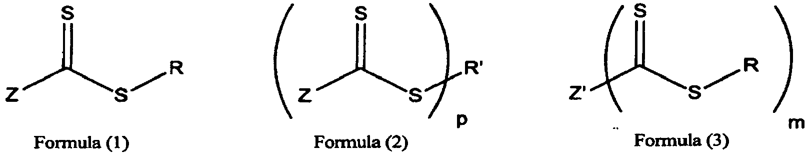 dans lesquelles Z représente un groupe choisi parmi un groupe alkyle, un groupe aryle et un groupe alkylthio, et chacun de ces groupes peut avoir un substituant, R représente un groupe choisi parmi un groupe alkyle et un groupe alkylthio, et chacun de ces groupes peut avoir un substituant, p représente un nombre entier de 2 à 6, m représente un nombre entier de 2 à 4, R' représente un groupe de connexion à valence p composé d'une combinaison des motifs développés suivants, et Z' représente un groupe de connexion à valence m composé d'au moins un cycle benzène :

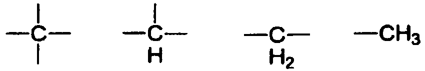

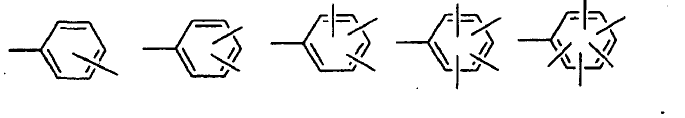

2. Précurseur de plaque d'impression lithographique selon la revendication 1, dans lequel l'agent de transfert de chaîne réversible par addition-fragmentation (C) est un composé représenté par la formule (2) ou (3).

3. Précurseur de plaque d'impression lithographique selon la revendication 1 ou 2, dans lequel un poids moléculaire moyen en poids de l'agent de transfert de chaîne réversible par addition-fragmentation (C) est de 1200 ou moins.

4. Précurseur de plaque d'impression lithographique selon l'une quelconque des revendications 1 à 3, dans lequel la couche d'impression d'image comprend (E) un composé de borate organique.

5. Précurseur de plaque d'impression lithographique selon la revendication 4, dans lequel le composé de borate organique (E) est le borate de tétraaryle.

6. Précurseur de plaque d'impression lithographique selon l'une quelconque des revendications 1 à 5, qui comprend une couche de protection.

7. Précurseur de plaque d'impression lithographique selon l'une quelconque des revendications 1 à 6, dans lequel le colorant de sensibilisation (D) présente une absorption maximum dans une plage de longueurs d'onde de 350 à 450 nm.

8. Précurseur de plaque d'impression lithographique selon l'une quelconque des revendications 1 à 6, dans lequel le colorant de sensibilisation (D) présente une absorption maximum dans une plage de longueurs d'onde de 750 à 1400 nm.

9. Précurseur de plaque d'impression lithographique selon l'une quelconque des revendications 1 à 8, dans lequel la couche d'impression d'image est une couche d'impression d'image pouvant former une image par enlèvement d'une zone non exposée en fournissant de l'encre d'impression et de l'eau de mouillage sur une machine d'impression après exposition.
